# EUROPEAN PATENT APPLICATION

(11) **EP 4 567 900 A1**
(43) Date of publication of application: **11.06.2025**
(21) Application number: 24184461.2
(22) Date of filing: 25.06.2024
(51) Int. Cl.: H01L 29/778, H01L 21/337, H01L 29/417, H01L 29/08, H01L 29/10, H01L 29/40, H01L 29/20

(54) **SEMICONDUCTOR DEVICE**

(30) Priority: 07.12.2023 KR 20230176898
(71) Applicant: Samsung Electronics Co., Ltd., Suwon-si, Gyeonggi-do 16677 (KR)
(72) Inventor: PARK, Junhyuk, Suwon-si (KR); KIM, Sanghyun, Suwon-si (KR); KIM, Jongseob, Suwon-si (KR); LEE, Jung-Wook, Suwon-si (KR); HWANG, In Jun, Suwon-si (KR)
(74) Representative: Marks & Clerk LLP

(57) **Abstract**

Various example embodiments provide a semiconductor device including a channel layer (132), a barrier layer (136) on the channel layer and including a material having an energy band gap different from that of the channel layer, a gate electrode (155) on the barrier layer, a gate semiconductor layer (152) between the barrier layer and the gate electrode, and a source electrode (173) and a drain electrode (175) on opposite sides of the gate electrode and penetrating at least a portion of the barrier layer and the channel layer to cover a side surface of the barrier layer and a side surface of the channel layer.

## Description

### BACKGROUND

Various example embodiments of the inventive concepts relate to a semiconductor device.

In modern society, semiconductor devices are closely related to daily life. Particularly, the importance of power semiconductor devices used in various fields, for example, transportation fields such as electric vehicles, railroads, and electric trams, renewable energy systems such as solar power generation and wind power generation, and mobile devices is gradually increasing. Power semiconductor devices are semiconductor devices used to handle high voltage or high current, and perform functions such as power conversion and control in large power systems or high-output electronic devices. Power semiconductor devices have the ability and durability to handle high power, so they may handle large amounts of current and withstand high voltage. For example, power semiconductor devices may handle voltages from hundreds of volts to thousands of volts and currents from tens of amperes to thousands of amperes. Power semiconductor devices may improve the efficiency of electrical energy by reducing (and/or minimizing) power loss. In addition, power semiconductor devices may be more stably driven even in environments such as high temperatures.

These power semiconductor devices may be classified according to materials, and examples thereof include SiC power semiconductor devices and GaN power semiconductor devices. By manufacturing power semiconductor devices using SiC or GaN instead of silicon (Si) wafers, the disadvantages of silicon having unstable characteristics at high temperatures may be reduced or compensated. SiC power semiconductor devices may be resistant to high temperatures, have low power loss, and be suitable for electric vehicles and renewable energy systems. GaN power semiconductor devices may be more efficient in terms of speed and be more suitable for high-speed charging of mobile devices.

### SUMMARY

Various example embodiments attempt to provide a semiconductor device with more stable electric characteristics.

Various example embodiments provide a semiconductor device including a channel layer, a barrier layer on the channel layer and including a material having an energy band gap different from that of the channel layer, a gate electrode on the barrier layer, a gate semiconductor layer between the barrier layer and the gate electrode, and a source electrode and a drain electrode on opposite sides of the gate electrode and penetrating at least a portion of the barrier layer and the channel layer to cover a side surface of the barrier layer and a side surface of the channel layer. The side surface of the barrier layer is inclined from an upper surface of the channel layer and includes a first inclined surface doped with an impurity, the side surface of the channel layer includes a second inclined surface inclined from the upper surface of the channel layer, and a first angle between a lower surface of the barrier layer and the first inclined surface of the barrier layer is smaller than or equal to a second angle between the upper surface of the channel layer and the second inclined surface of the channel layer.

The drain electrode and the source electrode may each cover a different side surface of the channel layer and a different side surface of the barrier layer. Reference to the side surface of the barrier layer may be understood to refer to any side surface of the barrier layer that is covered by the source electrode and any side surface of the barrier layer that is covered by the drain electrode. The side surface of the barrier layer covered by the drain electrode and the side surface of the barrier layer covered by the source electrode may each include a first inclined surface having the features described above. The side surface of the channel layer covered by the drain electrode and the side surface of the channel layer covered by the source electrode may each include a second inclined surface having the features described above.

The side surface of the channel layer that is covered by the source electrode and the side surface of the channel layer that is covered by the drain electrode may each be side surfaces of a respective recess formed within the channel layer. Therefore, the side surfaces of the channel layer may extend across only part the cross-section of the channel layer.

The side surface of the barrier layer is inclined from the upper surface of the channel layer, so that the angle (i.e. the first angle) between the side surface of the barrier layer and the upper surface of the channel layer is less than 90°.

The side surface of the channel layer is inclined from the upper surface of the channel layer, so that the angle (i.e. the second angle) between the side surface of the channel layer and the upper surface of the channel layer is less than 90°.

In some embodiments, the first inclined surface of the barrier layer is doped with an n-type impurity. In this case, the impurity referred to above is the n-type impurity.

In some embodiments, the semiconductor device further comprises a spacer layer between the channel layer and the barrier layer, wherein a side surface of the spacer layer includes a third inclined surface inclined from the upper surface of the channel layer. The third inclined surface may be inclined from the side surface of the spacer layer such that an angle between the third inclined surface and the upper surface of the channel layer is less than 90°.

Other various example embodiments provide a semiconductor device including a channel layer, a barrier layer on the channel layer and including a material having an energy band gap different from that of the channel layer, a gate electrode on the barrier layer, a gate semiconductor layer between the barrier layer and the gate electrode, and a source electrode and a drain electrode on opposite sides of the gate electrode and penetrating at least a portion of the barrier layer and the channel layer to cover a side surface of the barrier layer and a side surface of the channel layer. The side surface of the barrier layer is inclined from an upper surface of the channel layer and includes a first inclined surface doped with an impurity, and a first angle between a lower surface of the barrier layer and the first inclined surface of the barrier layer is greater than 0 degrees and less than or equal to 70 degrees.

Other various example embodiments provide a semiconductor device including a substrate, a channel layer including GaN on the substrate, a barrier layer on the channel layer and including AlGaN, a gate electrode extending in a first direction, on the barrier layer, and including a metal material, a gate semiconductor layer extending in the first direction, between the barrier layer and the gate electrode, and including GaN doped with a p-type impurity, and a source electrode and a drain electrode spaced apart from each other in a second direction crossing the first direction on opposite sides of the gate electrode, and penetrating at least a portion of the barrier layer and the channel layer to cover a side surface of the barrier layer and a side surface of the channel layer. The side surfaces of the barrier layer facing each other in the first direction include a first inclined surface that is inclined from an upper surface of the channel layer and is doped with an impurity, the side surfaces of the channel layer facing each other in the first direction include a second inclined surface inclined from the upper surface of the channel layer, and a first angle between a lower surface of the barrier layer and the first inclined surface of the barrier layer is smaller than or equal to a second angle between the upper surface of the channel layer and the second inclined surface of the channel layer.

According to various example embodiments, it is possible to improve electric characteristics of a semiconductor device.

At least some of the above and other features of the invention are set out in the claims.

### BRIEF DESCRIPTION OF THE DRAWINGS

FIG. 1 illustrates a top plan view of a semiconductor device according to various example embodiments.
FIG. 2 and FIG. 3 illustrate cross-sectional views taken along line A-A' of FIG. 1.
FIG. 4 illustrates a cross-sectional view taken along line B-B' of FIG. 1.
FIG. 5 illustrates an enlarged cross-sectional view of area "A1" of FIG. 4.
FIG. 6 to FIG. 8 illustrate cross-sectional views corresponding to area "A1" of FIG. 4 illustrating a semiconductor device according to some example embodiments.
FIG. 9 to FIG. 11 illustrate cross-sectional views of a semiconductor device according to some example embodiments.
FIG. 12 illustrates an enlarged cross-sectional view of area "A2" of FIG. 11.
FIG. 13 illustrates a cross-sectional view of area "A2" of FIG. 12 illustrating a semiconductor device according to some example embodiments.
FIG. 14 illustrates a cross-sectional view of a semiconductor device according to some example embodiments.
FIG. 15 to FIG. 17 illustrate top plan views of a semiconductor device according to some example embodiments.
FIG. 18 illustrates a cross-sectional view taken along line C-C' of FIG. 17.
FIG. 19 to FIG. 27 illustrates cross-sectional views of a manufacturing method of a semiconductor device according to some example embodiments.

### DETAILED DESCRIPTION

Example embodiments of the inventive concepts will be described more fully hereinafter with reference to the accompanying drawings, in which various example embodiments are shown. As those skilled in the art would realize, the described various example embodiments may be modified in various different ways, all without departing from the scope of the inventive concepts.

In order to clearly describe various example embodiments of the inventive concepts, parts or portions that are irrelevant to the description are omitted, and identical or similar constituent elements throughout the specification are denoted by the same reference numerals.

Furthermore, in the drawings, the size and thickness of each element are arbitrarily illustrated for ease of description, and various example embodiments are not necessarily limited to those illustrated in the drawings. In the drawings, the thicknesses of layers, films, panels, regions, areas, etc., are exaggerated for clarity. In the drawings, for ease of description, the thicknesses of some layers and areas are exaggerated.

It will be understood that when an element such as a layer, film, region, area, or substrate is referred to as being "on" or "above" another element, it can be directly on the other element or intervening elements may also be present. In contrast, when an element is referred to as being "directly on" another element, there are no intervening elements present. Further, in the specification, the word "on" or "above" means disposed on or below the object portion, and does not necessarily mean disposed on the upper side of the object portion based on a gravitational direction.

In addition, unless explicitly described to the contrary, the word "comprise" and variations such as "comprises" or "comprising" will be understood to imply the inclusion of stated elements but not the exclusion of any other elements.

Furthermore, throughout the specification, the phrase "in a plan view" or "on a plane" means viewing a target portion from the top, and the phrase "in a cross-sectional view" or "on a cross-section" means viewing a cross-section formed by vertically cutting a target portion from the side.

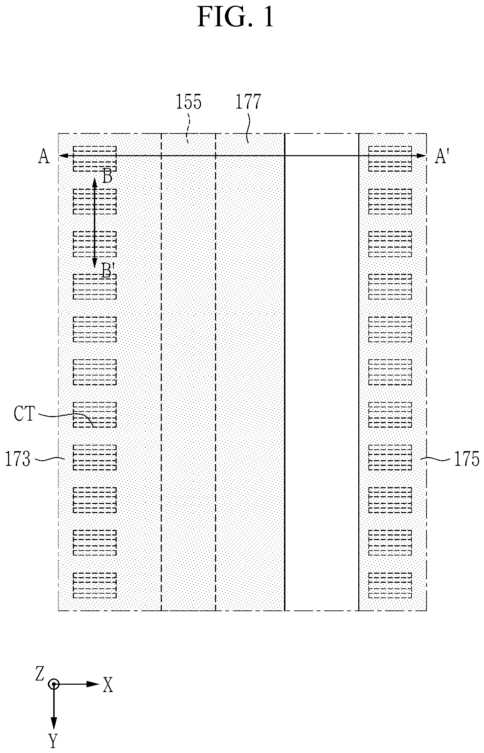

Hereinafter, a semiconductor device according to various example embodiments will be described with reference to FIG. 1 to FIG. 5.

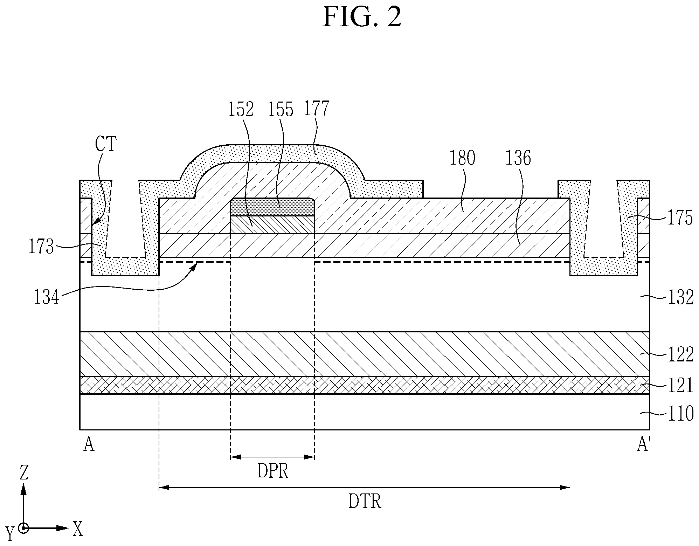

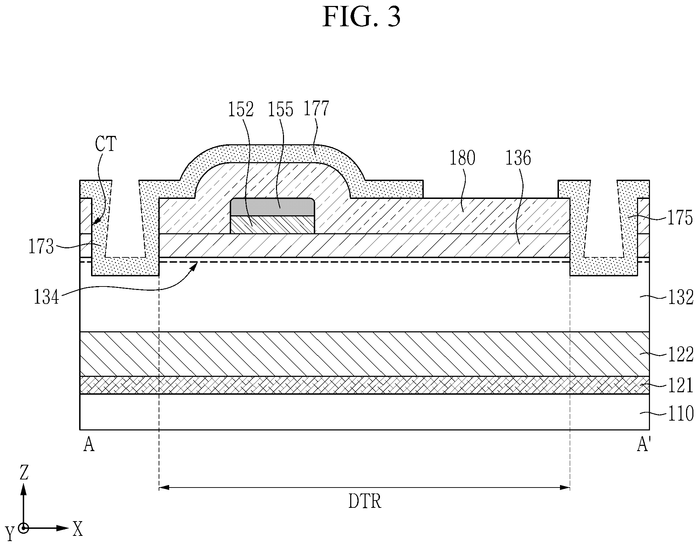

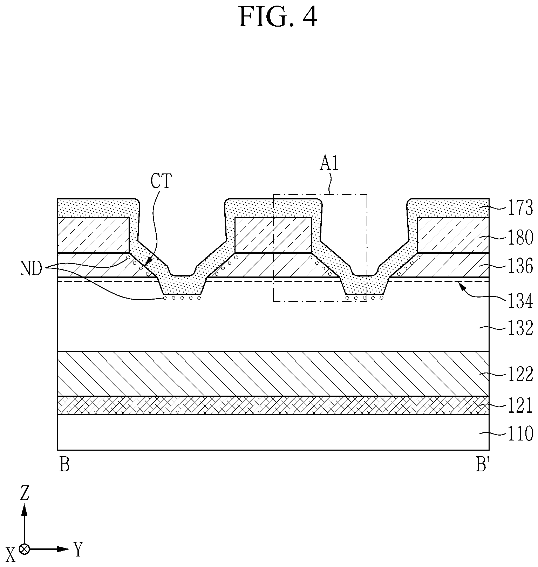

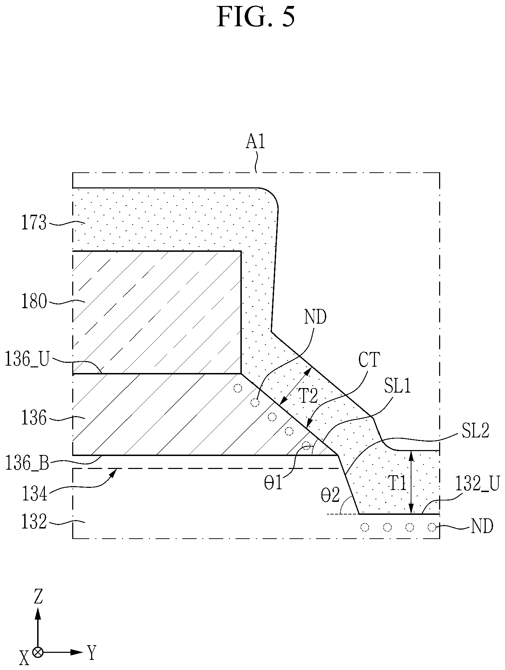

FIG. 1 illustrates a top plan view of a semiconductor device according to various example embodiments. FIG. 2 and FIG. 3 illustrate cross-sectional views taken along line A-A' of FIG. 1. FIG. 4 illustrates a cross-sectional view taken along line B-B' of FIG. 1. FIG. 5 illustrates an enlarged cross-sectional view of area "A1" of FIG. 4. FIG. 2 illustrates a case in which a semiconductor device according to various example embodiments is in an off state, and FIG. 3 illustrates a case in which a semiconductor device according to various example embodiments is in an on state.

First, as shown in FIG. 1 and FIG. 2, a semiconductor device according to various example embodiments includes a channel layer 132, a barrier layer 136 disposed on the channel layer 132, a gate electrode 155 disposed on the barrier layer 136, a gate semiconductor layer 152 disposed between the barrier layer 136 and the gate electrode 155, a passivation layer 180 disposed on the barrier layer 136, and a source electrode 173 and a drain electrode 175 spaced apart from each other on the channel layer 132.

The channel layer 132 is a layer that forms a channel between the source electrode 173 and the drain electrode 175, and a 2-dimensional electron gas (2DEG) 134 may be disposed inside the channel layer 132. The two-dimensional electron gas 134, in a charge transport model used in solid physics, refers to a group of electrons that may move freely in two dimensions (for example, a plane formed in a first direction (X direction) and a second direction (Y direction)) but may not moved in one dimension (for example, a third direction (Z direction)) to be tightly confined within two dimensions. In other words, the two-dimensional electron gas 134 may exist in a 2-dimensional paper-like form within a 3-dimensional space. The two-dimensional electron gas 134 mainly appears in a semiconductor heterojunction structure, and in the semiconductor device according to the embodiment, may occur at an interface between the channel layer 132 and the barrier layer 136. For example, the two-dimensional electron gas 134 may be generated in a portion closest to the barrier layer 136 within the channel layer 132.

The channel layer 132 may include one or more materials selected from Group III-V materials, for example, nitrides including Al, Ga, In, B, or a combination thereof. However, example embodiments are not limited thereto. The channel layer 132 may be formed as a single layer or a multilayer. The channel layer 132 may be AlₓIn_{y}Ga_{1-x-y}N(0≤x≤1, 0≤y≤1, x+y≤1). For example, the channel layer 132 may include AlN, GaN, InN, InGaN, AlGaN, AlInN, AlInGaN, or a combination thereof. However, example embodiments are not limited thereto. The channel layer 132 may be a layer doped with impurities or a layer undoped with impurities. A thickness of the channel layer 132 may be about several hundred nm or less.

The channel layer 132 may be disposed on a substrate 110, and a seed layer 121 and a buffer layer 122 may be disposed between the substrate 110 and the channel layer 132. The substrate 110, the seed layer 121, and the buffer layer 122 are layers required to form the channel layer 132, and may be omitted in some cases. For example, when a substrate made of GaN is used as the channel layer 132, at least one of the substrate 110, the seed layer 121, and the buffer layer 122 may be omitted. Considering that the price of the substrate made of GaN is relatively high, the channel layer 132 including GaN may be grown using the substrate 110 made of Si. In this case, it may not be easy to grow the channel layer 132 directly on the substrate 110 because a lattice structure of Si and a lattice structure of GaN are different. Accordingly, the seed layer 121 and the buffer layer 122 may be first grown on the substrate 110, and then the channel layer 132 may be grown on the buffer layer 122. In addition, at least one of the substrate 110, the seed layer 121, and the buffer layer 122 may be used in the manufacturing process and then removed from the final structure of the semiconductor device.

The substrate 110 may include a semiconductor material. For example, the substrate 110 may include sapphire, Si, SiC, AlN, GaN, or a combination thereof. The substrate 110 may be a silicon on insulator (SOI) substrate. However, the material of the substrate 110 in the example embodiments is not limited thereto, and all generally used substrates may be applied. In some cases, the substrate 110 may include an insulating material. For example, several layers, including the channel layer 132, may be first formed on a semiconductor substrate, and then the semiconductor substrate may be removed and replaced with an insulating substrate.

The buffer layer 122 may be disposed on the substrate 110. The seed layer 121 may be further disposed between the substrate 110 and the buffer layer 122. The seed layer 121 may be disposed directly on the substrate 110. However, example embodiments are not limited thereto, and another desired (or, alternatively an empirically or predetermined) layer may be further disposed between the substrate 110 and the seed layer 121. The seed layer 121 is a layer that serves as a seed for growing the buffer layer 122, and may be formed of a crystal lattice structure that becomes the seed of the buffer layer 122. The buffer layer 122 may be disposed directly on the seed layer 121. However, example embodiments are not limited thereto, and another desired (or, alternatively an empirically or predetermined) layer may be further disposed between the seed layer 121 and the buffer layer 122. The seed layer 121 may include one or more materials selected from Group III-V materials, for example, nitrides including Al, Ga, In, B, or a combination thereof. The seed layer 121 may be AlₓIn_{y}Ga_{1-x-y}N(0≤x≤1, 0≤y≤1, x+y≤1).For example, the seed layer 121 may include AlN, GaN, InN, InGaN, AlGaN, AlInN, AlInGaN, or a combination thereof. However, example embodiments are not limited thereto.

The buffer layer 122 may be disposed between the substrate 110 and the channel layer 132. The buffer layer 122 is a layer for alleviating a difference in lattice constant and thermal expansion coefficient between the substrate 110 and the channel layer 132. The buffer layer 122 may include one or more materials selected from Group III-V materials, for example, nitrides including Al, Ga, In, B, or a combination thereof. The buffer layer 122 may be AlₓIn_{y}Ga_{1-x-y}N(0≤x≤1, 0≤y≤1, x+y≤1).For example, the buffer layer 122 may include AlN, GaN, InN, InGaN, AlGaN, AlInN, AlInGaN, or a combination thereof. However, example embodiments are not limited thereto. The buffer layer 122 may be formed as a single layer or a multilayer.

The buffer layer 122 of the semiconductor device according to the embodiment may further include an ultralattice layer and/or a high-resistance layer.

The ultralattice layer may be disposed on the seed layer 121. The ultralattice layer may be disposed directly on the seed layer 121. However, example embodiments are not limited thereto, and another desired (or, alternatively an empirically or predetermined) layer may be further disposed between the seed layer 121 and the ultralattice layer. The ultralattice layer is a layer for alleviating differences in lattice constants and/or thermal expansion coefficients between the substrate 110 and the channel layer 132. The ultralattice layer may include one or more materials selected from Group III-V materials, for example, nitrides including Al, Ga, In, B, or a combination thereof. The ultralattice layer may be AlₓIn_{y}Ga_{1-x-y}N(0≤x≤1, 0≤y≤1, x+y≤1).For example, the ultralattice layer may include AlN, GaN, InN, InGaN, AlGaN, AlInN, AlInGaN, or a combination thereof. However, example embodiments are not limited thereto. The ultralattice layer may be formed as a single layer or a multilayer. For example, the ultralattice layer may have a structure in which a layer made of AlGaN and a layer made of GaN are repeatedly stacked. For example, AlGaN/GaN/AlGaN/GaN/AlGaN/GaN may be sequentially stacked on the seed layer 121 to form an ultralattice layer. The number of AlGaN layers and GaN configuring the ultralattice layer may be variously changed, and the material configuring the ultralattice layer may be variously changed.

The high-resistance layer may be disposed on the ultralattice layer. The high-resistance layer may be disposed directly on the ultralattice layer. However, example embodiments are not limited thereto, and another desired (or, alternatively an empirically or predetermined) layer may be disposed between the ultralattice layer and the high-resistance layer. The high-resistance layer may be disposed between the ultralattice layer and the channel layer 132. The high-resistance layer may reduce or prevent the semiconductor device from deteriorating by blocking the flow of leakage current. The high-resistance layer may be made of a material with low-conductivity to electrically insulate the substrate 110 and the channel layer 132. The high-resistance layer may include one or more materials selected from Group III-V materials, for example, nitrides including Al, Ga, In, B, or a combination thereof. The high-resistance layer may be AlₓIn_{y}Ga_{1-x-y}N(0≤x≤1, 0≤y≤1, x+y≤1). For example, the high-resistance layer may include AlN, GaN, InN, InGaN, AlGaN, AlInN, AlInGaN, or a combination thereof. However, example embodiments are not limited thereto. The high-resistance layer may be formed as a single layer or a multilayer. The high-resistance layer may be a layer that is not doped with impurities.

The barrier layer 136 may be disposed on the channel layer 132. A region of the channel layer 132 that overlaps the barrier layer 136 may be a drift region DTR. The drift region DTR may be disposed between the source electrode 173 and the drain electrode 175. The drift region DTR may mean a region in which a carrier moves when a potential difference occurs between the source electrode 173 and the drain electrode 175. The semiconductor device according to the embodiment may be turned on/off according to whether a voltage is applied to the gate electrode 155 and/or the magnitude of the voltage applied to the gate electrode 155, and accordingly, carrier movement in the drift region DTR may be performed or blocked.

The barrier layer 136 may include one or more materials selected from Group III-V materials, for example, nitrides including Al, Ga, In, B, or a combination thereof. The barrier layer 136 may be AlₓIn_{y}Ga_{1-x-y}N(0≤x≤1, 0≤y≤1, x+y≤1).The barrier layer 136 may include GaN, InN, AlGaN, AlInN, InGaN, AlN, AlInGaN, or a combination thereof. However, example embodiments are not limited thereto. An energy band gap of barrier layer 136 may be adjusted by a composition ratio of Al and/or In. The barrier layer 136 may be doped with a desired (or, alternatively an empirically or predetermined) impurity. By increasing or decreasing the impurity doping concentration of the barrier layer 136, the threshold voltage, temperature resistance, and the like of the semiconductor device according to the embodiment may be adjusted.

The barrier layer 136 may include a semiconductor material with characteristics different from those of the channel layer 132. The barrier layer 136 may be different from the channel layer 132 in at least one of polarization characteristic, energy band gap, and lattice constant. For example, the barrier layer 136 may include a material having an energy band gap different from that of the channel layer 132. In this case, the barrier layer 136 may have a higher energy band gap than the channel layer 132, and may have a higher electrical polarization rate than the channel layer 132. The two-dimensional electron gas 134 may be induced in the channel layer 132 having a relatively low electrical polarization rate by the barrier layer 136. In this regard, the barrier layer 136 may be referred to as a channel supply layer or a two-dimensional electron gas supply layer. The two-dimensional electron gas 134 may be formed within a portion of the channel layer 132 disposed below the interface between the channel layer 132 and the barrier layer 136. The two-dimensional electron gas 134 may have very high electron mobility.

The barrier layer 136 may be formed as a single layer or a multilayer. When the barrier layer 136 is formed as a multilayer, the material of respective layers configuring the multilayer may have different energy band gaps. In this case, several layers configuring the barrier layer 136 may be disposed such that the energy band gap increases as the barrier layer 136 is closer to the channel layer 132.

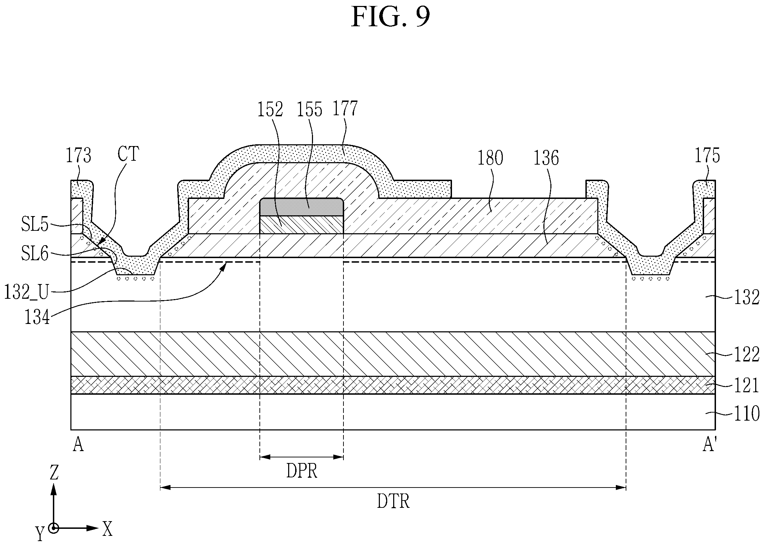

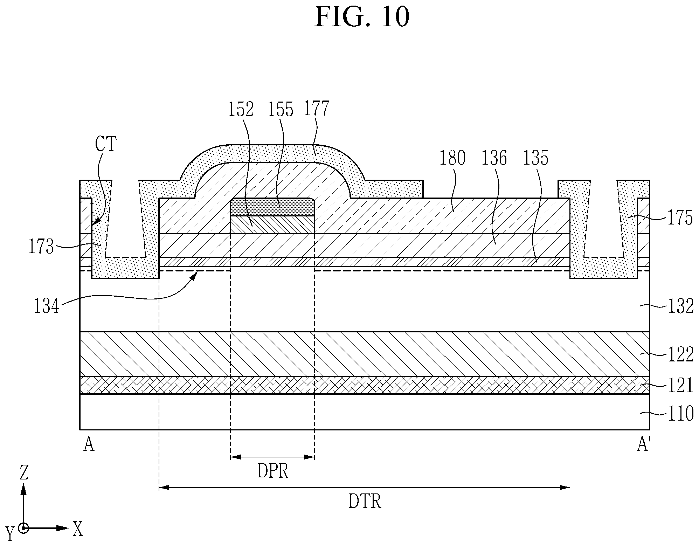

In various example embodiments, the barrier layer 136 is described as being disposed directly on the channel layer 132, but example embodiments are not limited thereto. For example, a spacer layer 135 (see FIG. 10) may be further disposed between the barrier layer 136 and the channel layer 132. This will be described later with reference to FIG. 9 to FIG. 14.

The gate electrode 155 may be disposed on the barrier layer 136. The gate electrode 155 may overlap a partial area of the barrier layer 136. The gate electrode 155 may overlap a portion of the drift region DTR of the channel layer 132. The gate electrode 155 may be disposed between the source electrode 173 and the drain electrode 175. The gate electrode 155 may be spaced apart from the source electrode 173 and the drain electrode 175. For example, the gate electrode 155 may be disposed closer to the source electrode 173 than the drain electrode 175. That is, the separation distance between the gate electrode 155 and the source electrode 173 may be smaller than the separation distance between the gate electrode 155 and the drain electrode 175, but example embodiments are not limited thereto.

The gate electrode 155 may include a conductive material. For example, the gate electrode 155 may include a metal, a metal alloy, a conductive metal nitride, a metal silicide, a doped semiconductor material, a conductive metal oxide, a conductive metal oxynitride, or the like. For example, the gate electrode 155 may include, for example, at least one of a titanium nitride (TiN), a tantalum carbide (TaC), a tantalum nitride (TaN), a titanium silicon nitride (TiSiN), a tantalum silicon nitride (TaSiN), a tantalum titanium nitride (TaTiN), a titanium aluminum nitride (TiAlN), a tantalum aluminum nitride (TaAlN), a tungsten nitride (WN), ruthenium (Ru), a titanium aluminum (TiAl), a titanium aluminum carbonitride (TiAlC-N), a titanium aluminum carbide (TiAlC), a titanium carbide (TiC), a tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), a niobium nitride (NbN), a niobium carbide (NbC), molybdenum (Mo), a molybdenum nitride (MoN), a molybdenum carbide (MoC), a tungsten carbide (WC), rhodium (Rh), palladium (Pd), iridium (Ir), osmium (Os), silver (Ag), gold (Au), zinc (Zn), vanadium (V), and a combination thereof, but example embodiments are not limited thereto. The gate electrode 155 may be formed as a single layer or a multilayer.

The gate semiconductor layer 152 may be disposed between the barrier layer 136 and the gate electrode 155. That is, the gate semiconductor layer 152 may be disposed on the barrier layer 136, and the gate electrode 155 may be disposed on the gate semiconductor layer 152. The gate electrode 155 may be in ohmic contact or Schottky contact with the gate semiconductor layer 152. The gate semiconductor layer 152 may overlap the gate electrode 155. In this case, the gate semiconductor layer 152 may completely overlap the gate electrode 155 in a vertical direction, and the upper surface of the gate semiconductor layer 152 may be entirely covered by the gate electrode 155. That is, the gate semiconductor layer 152 may have substantially the same planar shape as the gate electrode 155. However, example embodiments are not limited thereto, and the gate electrode 155 may be disposed to cover at least a portion of the gate semiconductor layer 152.

The gate semiconductor layer 152 may be disposed between the source electrode 173 and the drain electrode 175. The gate semiconductor layer 152 may be spaced apart from the source electrode 173 and the drain electrode 175. The gate semiconductor layer 152 may be disposed closer to the source electrode 173 than the drain electrode 175. That is, the separation distance between the gate semiconductor layer 152 and the source electrode 173 may be smaller than the separation distance between the gate semiconductor layer 152 and the drain electrode 175, but example embodiments are not limited thereto.

In various example embodiments, the gate semiconductor layer 152 may overlap the gate electrode 155 in the third direction (Z direction). For example, the gate semiconductor layer 152 may completely overlap the gate electrode 155 in the third direction (Z direction). That is, a side surface of the gate semiconductor layer 152 may be aligned with a side surface of the gate electrode 155. However, example embodiments are not limited thereto, and the gate semiconductor layer 152 may partially overlap the gate electrode 155.

The gate semiconductor layer 152 may include one or more materials selected from Group III-V materials, for example, nitrides including Al, Ga, In, B, or a combination thereof. The gate semiconductor layer 152 may be AlₓIn_{y}Ga_{1-x-y}N(0≤x≤1, 0≤y≤1, x+y≤1). For example, the gate semiconductor layer 152 may include AlN, GaN, InN, InGaN, AlGaN, AlInN, AlInGaN, or a combination thereof. However, example embodiments are not limited thereto. The gate semiconductor layer 152 may include a material having an energy band gap different from that of the barrier layer 136. For example, the gate semiconductor layer 152 may include GaN, and the barrier layer 136 may include AlGaN. The gate semiconductor layer 152 may be doped with a desired (or, alternatively an empirically or predetermined) impurity. In this case, the impurity doped in the gate semiconductor layer 152 may be a p-type dopant that may provide a hole. For example, the gate semiconductor layer 152 may include GaN doped with a p-type impurity. That is, the gate semiconductor layer 152 may be formed as a p-GaN layer. However, example embodiments are not limited thereto, and the gate semiconductor layer 152 may be a p-AlGaN layer. The impurity doped in the gate semiconductor layer 152 may be magnesium (Mg). In this case, when a desired (or, alternatively an empirically or predetermined) element adjacent to an impurity (for example, magnesium) doped in the gate semiconductor layer 152 combines, a hole concentration in the gate semiconductor layer 152 may be reduced, thereby deteriorating the characteristics of the semiconductor device. The gate semiconductor layer 152 may be formed of a single layer or a multilayer.

A depletion region DPR may be formed in the channel layer 132 by the gate semiconductor layer 152. The depletion region DPR may be disposed within the drift region DTR and may have a narrower width than the drift region DTR. As the gate semiconductor layer 152 having an energy band gap different from that of the barrier layer 136 is disposed on the barrier layer 136, a level of an energy band of a portion of the barrier layer 136 overlapping the gate semiconductor layer 152 may be increased. Accordingly, the depletion region DPR may be formed in a region of the channel layer 132 that overlaps the gate semiconductor layer 152. The depletion region DPR may be a region in a channel path of the channel layer 132 in which the two-dimensional electron gas 134 is not formed or that may have a lower electron concentration than the remaining regions. That is, the depletion region DPR may mean a region in which the flow of the two-dimensional electron gas 134 is interrupted within the drift region DTR. As the depletion region DPR is generated, no current flows between the source electrode 173 and the drain electrode 175, and the channel path may be blocked. Accordingly, the semiconductor device according to various example embodiments may have a normally-off characteristic.

That is, the semiconductor device according to various example embodiments may be a normally-off high electron mobility transistor (HEMT). As shown in FIG. 2, in a normal state in which no voltage is applied to the gate electrode 155, the depletion region DPR may exist, and the semiconductor device according to various example embodiments may be in an off state. As shown in FIG. 3, when a voltage higher than a threshold voltage is applied to the gate electrode 155, the depletion region DPR disappears, and the two-dimensional electron gas 134 may be continued without being interrupted in the drift region DTR. That is, the two-dimensional electron gas 134 may be formed throughout the channel path between the source electrode 173 and the drain electrode 175, and the semiconductor device according to various example embodiments may be in an on state.

In summary, the semiconductor device according to the embodiment may include semiconductor layers having different electrical polarization characteristics, and a semiconductor layer having a relatively large polarization rate may cause a two-dimensional electron gas 134 in a heterogeneous junction with another semiconductor layer . The two-dimensional electron gas 134 may be used as a channel between the source electrode 173 and the drain electrode 175, and the continuation or interruption of the flow of the two-dimensional electron gas 134 may be controlled by the bias voltage applied to the gate electrode 155. In the gate-off state, the flow of the two-dimensional electron gas 134 is blocked, so that no current may flow between the source electrode 173 and the drain electrode 175. In the gate-on state, as the flow of the two-dimensional electron gas 134 continues, a current may flow between the source electrode 173 and the drain electrode 175.

The seed layer 121, the buffer layer 122, the channel layer 132, the barrier layer 136, and gate semiconductor layer 152 described above may be sequentially stacked on the substrate 110. In the semiconductor device according to the embodiment, at least one of the seed layer 121, the buffer layer 122, the channel layer 132, the barrier layer 136, and the gate semiconductor layer 152 may be omitted. The seed layer 121, the buffer layer 122, the channel layer 132, the barrier layer 136, and the gate semiconductor layer 152 may be made of the same-based semiconductor material, and the material composition ratios of respective layers may be different in consideration of roles and performance of respective layers required for the semiconductor device.

The passivation layer 180 may be disposed on the barrier layer 136 and the gate electrode 155. The passivation layer 180 may cover upper and side surfaces of the gate electrode 155 and a side surfaces of the gate semiconductor layer 152. A lower surface of the passivation layer 180 may be in contact with the barrier layer 136 and the gate electrode 155. Accordingly, the barrier layer 136, the gate semiconductor layer 152, and the gate electrode 155 may be protected by the passivation layer 180. However, example embodiments are not limited thereto, and the gate electrode 155 may penetrate the passivation layer 180 to be connected to the gate semiconductor layer 152, and the passivation layer 180 may not cover the upper surface of the gate electrode 155. Alternatively, the lower surface of the passivation layer 180 may be in contact with the gate semiconductor layer 152.

In various example embodiments, the passivation layer 180 may be disposed between the barrier layer 136 and a field dispersion layer 177, which will be described later. At least a portion of the passivation layer 180 may overlap the field dispersion layer 177 in the third direction (Z direction). Accordingly, the portion of the passivation layer 180 that overlaps the field dispersion layer 177 in the third direction (Z direction) may cover the gate semiconductor layer 152 and the gate electrode 155.

In the embodiment, the passivation layer 180 may include an insulating material. For example, the passivation layer 180 may include a silicon oxide (SiO₂), a silicon nitride (SiN), a silicon nitride (SiON), an aluminum oxide (Al₂O₃), or a combination thereof. Accordingly, moisture or oxygen may be reduced or prevented from penetrating into the channel layer 132, and an incomplete dangling bond state of the insulating material disposed at the interface of the barrier layer 136 may be removed.

In various example embodiments, the passivation layer 180 may be formed of a single layer or a multilayer. For example, in some cases, the passivation layer 180 may include two or more layers.

Referring further to FIG. 4 and FIG. 5, the semiconductor device according to various example embodiments may include a source/drain trench CT that penetrates the passivation layer 180 and the barrier layer 136 and recesses at least a portion of the channel layer 132. The source electrode 173 and the drain electrode 175 may be disposed within the source/drain trench CT. The source/drain trench CT may include side surfaces facing each other in the first direction (X direction) and side surfaces facing each other in the second direction (Y direction).

Specifically, as shown in FIG. 3 and FIG. 4, the source/drain trench CT penetrating the passivation layer 180 and the barrier layer 136 and recessing the upper surface of the channel layer 132 may be disposed on both sides of the gate electrode 155 to be spaced apart from each other in the first direction (X direction). In addition, a plurality of source/drain trenches CT may be provided, and the plurality of source/drain trenches CT may be arranged along the second direction (Y direction). The plurality of source/drain trenches CT may be disposed to be spaced apart from each other in the second direction (Y direction).

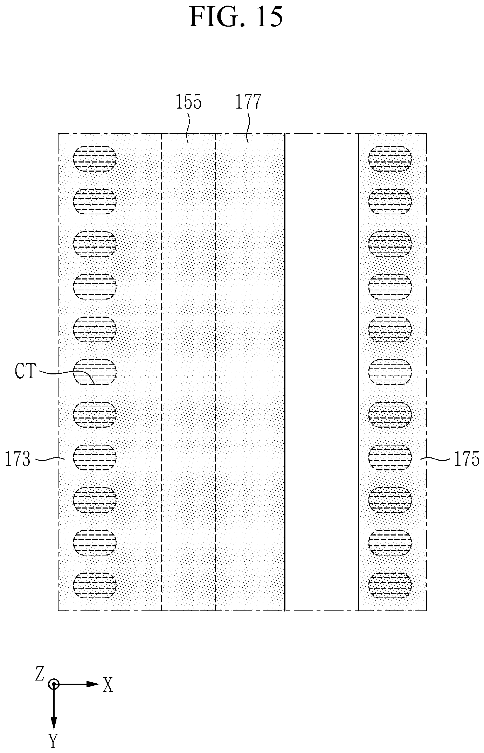

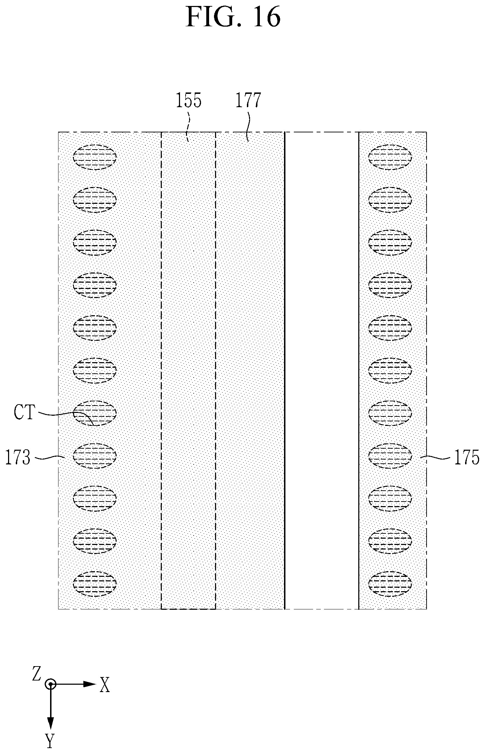

The source/drain trench CT may have a quadrangular shape in a plan view, as shown in FIG. 1. For example, the source/drain trench CT may have a rectangular shape with a long side extending along the first direction (X direction). However, example embodiments are not limited thereto, and the source/drain trench CT may have various shapes in a plan view. This will be described later with reference to FIG. 15 and FIG. 16.

In various example embodiments, the side surface of the source/drain trench CT may be defined as a side surface of the channel layer 132, a side surface of the barrier layer 136, and a side surface of the passivation layer 180. For example, the side surfaces of the source/drain trench CT facing each other in the first direction (X direction) may be defined as the side surfaces of the channel layer 132 facing each other in the first direction (X direction), the side surfaces of the barrier layer 136 facing each other in the first direction (X direction), and the side surfaces of the passivation layer 180 facing each other in the first direction (X direction). In addition, the side surfaces of the source/drain trench CT facing each other in the second direction (Y direction) may be defined as the side surfaces of the channel layer 132 facing each other in the second direction (Y direction), the side surfaces of the barrier layer 136 facing each other in the second direction (Y direction), and the side surfaces of the passivation layer 180 facing each other in the second direction (Y direction).

In this case, as illustrated in FIG. 5, the side surface of the barrier layer 136 may include an inclined surface. For example, the side surfaces of the barrier layer 136 facing each other in the second direction (Y direction) may include first inclined surfaces SL1. The first inclined surface SL1 of the barrier layer 136 may be a surface inclined at a desired (or, alternatively an empirically or predetermined) angle from a lower surface 136_B of the barrier layer 136. For example, a first angle θ1 between the first inclined surface SL1 and the lower surface 136_B of the barrier layer 136 may be greater than 0° and less than or equal to 70°. Within this range, impurities ND may be easily doped into the first inclined surface SL1 of the barrier layer 136. Accordingly, a width of an upper surface 136_U of the barrier layer 136 in the second direction (Y direction) may be smaller than a width of the lower surface 136_B of the barrier layer 136 in the second direction (Y direction).

Meanwhile, the side surfaces of the barrier layers 136 that face each other in the first direction (X direction) may be vertical surfaces perpendicular to the lower surface 136_B of the barrier layer 136. In this case, the width of the upper surface 136_U of the barrier layer 136 in the first direction (X direction) may be substantially the same as the width of the lower surface 136_B of the barrier layer 136 in the first direction (X direction). However, example embodiments are is not limited thereto, and the side surfaces of the barrier layer 136 facing each other in the first direction (X direction) may include inclined surfaces. This will be described later with reference to FIG. 9.

In various example embodiments, the first inclined surface SL1 of the barrier layer 136 may be doped with the impurities ND. For example, the first inclined surface SL1 of the barrier layer 136 may be doped with n-type impurities. The first inclined surface SL1 of the barrier layer 136 may be doped with Si, Ge, or a combination thereof. The impurities ND may be doped substantially uniformly on the first inclined surface SL1 of the barrier layer 136. That is, the entire first inclined surface SL1 of the barrier layer 136 may be doped with the impurities ND. The impurities ND doped on the first inclined surface SL1 of the barrier layer 136 may be formed by an ion implant process, a plasma treatment process, a heat treatment process, or the like. In this case, since the barrier layer 136 includes the first inclined surface SL1 having a desired (or, alternatively an empirically or predetermined) angle from the lower surface of the barrier layer 136, when impurities are implanted into the side surface of the barrier layer 136, they may be easily doped into the first inclined surface SL1 of the barrier layer 136. Accordingly, the carrier may be additionally implanted through the first inclined surface SL1 of the barrier layer 136. In other words, the first inclined surface SL1 of the barrier layer 136 may function as an additional carrier implant passage.

In various example embodiments, the side surface of the channel layer 132 may include an inclined surface. For example, the side surfaces of the channel layer 132 facing each other in the second direction (Y direction) may include second inclined surfaces SL2. The second inclined surface SL2 may be a surface inclined at a desired (or, alternatively an empirically or predetermined) angle from an upper surface 132_U of the channel layer 132. A second angle θ2 between the second inclined surface SL2 and the upper surface 132_U of the channel layer 132 may be greater than or equal to the first angle θ1. This may be due to the process characteristics of simultaneously forming the first inclined surface SL1 of the barrier layer 136 and the second inclined surface SL2 of the channel layer 132 by using an etching material having an etching rate higher in the channel layer 132 than in the barrier layer 136 in the process of etching the channel layer 132 and the barrier layer 136 together. However, example embodiments are is not limited thereto, and in the process of etching the channel layer 132 and the barrier layer 136 together, the first inclined surface SL1 and the second inclined surface SL2 may be simultaneously formed by adjusting the etching conditions so that the etching rate of the channel layer 132 is higher than that of the barrier layer 136. Here, the upper surface 132_U of the channel layer 132 may mean a surface defining the lower surface of the source/drain trench CT. Meanwhile, the side surfaces of the channel layer 132 facing each other in the first direction (X direction) may be vertical surfaces perpendicular to the upper surfaces of the channel layer 132, but are not limited thereto. This will be described later with reference to FIG. 9.

In various example embodiments, the upper surface 132_U of the channel layer 132 may be doped with the impurities ND. The impurities doped on the upper surface 132_U of the channel layer 132 may include the same material as the impurities doped on the first inclined surface SL1 of the barrier layer 136. For example, the upper surface 132_U of the channel layer 132 may be doped with n-type impurities. The upper surface 132_U of the channel layer 132 may be doped with Si, Ge, or a combination thereof. However, example embodiments are not limited thereto. In this case, the concentration of the impurities doped on the upper surface 132_U of the channel layer 132 may be greater than the concentration of the impurities doped on the first inclined surface SL1 of the barrier layer 136. In addition, the impurities ND may be doped substantially uniformly on the upper surface of the channel layer 132. That is, the entire upper surface of the channel layer 132 may be doped with the impurities ND. The impurities ND doped on the upper surface 132_U of the channel layer 132 may be formed by an ion implant process, a plasma treatment process, a heat treatment process, or the like.

Although FIG. 5 illustrates that the upper surface 132_U of the channel layer 132 is doped with the impurities ND, example embodiments are not limited thereto. For example, the second inclined surface SL2 of the channel layer 132 may be doped with impurities. The impurities doped on the second inclined surface SL2 of the channel layer 132 may include the same material as the impurities ND doped on the upper surface 132_U of the channel layer 132. In this case, the concentration of the impurities doped on the second inclined surface SL2 of the channel layer 132 may be less than the concentration of the impurities ND doped on the upper surface 132_U of the channel layer 132. In addition, due to the exposed side area, the concentration of the impurities doped in the second inclined surface SL2 of the channel layer 132 may be less than the concentration of the impurities ND doped on the first inclined surface SL1 of the barrier layer 136. In addition, the impurities ND may be doped substantially uniformly on the second inclined surface SL2 of the channel layer 132. That is, the entire second inclined surface SL2 of the channel layer 132 may be doped with the impurities ND.

In the semiconductor device according to various example embodiments, since the barrier layer 136 includes the first inclined surface SL1 and the channel layer 132 includes the second inclined surface SL2, the drift region DTR in which the barrier layer 136 and the channel layer 132 overlap in the third direction (Z direction) may be increased.

Referring back to FIG. 2, the source electrode 173 and the drain electrode 175 may be disposed in the source/drain trench CT disposed on opposite sides of the gate electrode 155, respectively.

The source electrode 173 and the drain electrode 175 may be disposed on the channel layer 132. The source electrode 173 and the drain electrode 175 may be in direct contact with the channel layer 132, and may be electrically connected to the channel layer 132. The source electrode 173 and the drain electrode 175 may be spaced apart from each other, and the gate electrode 155 and the gate semiconductor layer 152 may be disposed between the source electrode 173 and the drain electrode 175. That is, the source electrode 173 and the drain electrode 175 may be spaced apart from each other in the first direction (X direction) and may be disposed on opposite sides of the gate electrode 155. Accordingly, the gate electrode 155 and the gate semiconductor layer 152 may be spaced apart from the source electrode 173 and the drain electrode 175 in the first direction (X direction). For example, the source electrode 173 may be electrically connected to the channel layer 132 at one side of the gate electrode 155, and the drain electrode 175 may be electrically connected to the channel layer 132 at the other side of the gate electrode 155.

The source electrode 173 and the drain electrode 175 may be disposed outside the drift region DTR of the channel layer 132. A boundary surface between the source electrode 173 and the channel layer 132 may be one edge of the drift region DTR. Likewise, a boundary surface between the drain electrode 175 and the channel layer 132 may be the other edge of the drift region DTR.

The source electrode 173 and the drain electrode 175 may be in contact with the channel layer 132 and the barrier layer 136 in the source/drain trench CT. Accordingly, the source electrode 173 and the drain electrode 175 may contact the upper surface 132_U and the side surface of the channel layer 132. For example, the source electrode 173 and the drain electrode 175 may be in contact with the side surfaces of the channel layer 132 facing each other in the first direction (X direction) and the side surfaces of the channel layer 132 facing each other in the second direction (Y direction). In addition, the source electrode 173 and the drain electrode 175 may be in contact with the side surface of the barrier layer 136. For example, the source electrode 173 and the drain electrode 175 may be in contact with the side surfaces of the barrier layer 136 facing each other in the first direction (X direction) and the side surfaces of the barrier layer 136 facing each other in the second direction (Y direction).

In various example embodiments, the source electrode 173 and the drain electrode 175 may cover the side surface of the passivation layer 180. The upper surfaces of the source electrode 173 and the drain electrode 175 may protrude from the upper surfaces of the passivation layer 180. In addition, at least one of the source electrode 173 and the drain electrode 175 may cover at least a portion of the upper surface of the passivation layer 180.

In various example embodiments, each of the source electrode 173 and the drain electrode 175 may extend in the second direction (Y direction). For example, as shown in FIG. 4, each of the source electrode 173 and the drain electrode 175 may fill a plurality of source/drain trenches CT arranged in the second direction (Y direction) on a cross-section consisting of the second direction (Y direction) and the third direction (Z direction). For example, the source electrode 173 may be disposed on the upper surface 132_U of the channel layer 132, the second inclined surface SL2 of the channel layer 132, the first inclined surface SL1 of the barrier layer 136, the side surface of the passivation layer 180, and the upper surface of the passivation layer 180. That is, the source electrode 173 and the drain electrode 175 may cover the second inclined surface SL2 of the channel layer 132 and the first inclined surface SL1 of the barrier layer 136.

In this case, the first thickness T1 of the source electrode 173 disposed on the upper surface 132_U of the channel layer 132 may be greater than or equal to the second thickness T2 of the source electrode 173 disposed on the first inclined surface SL1 of the barrier layer 136. In addition, the thickness of the source electrode 173 disposed on the side surface of the passivation layer 180 may be smaller than the second thickness T2 of the source electrode 173 disposed on the first inclined surface SL1 of the barrier layer 136, but example embodiments are not limited thereto.

In the semiconductor device according to various example embodiments, the barrier layer 136 includes the first inclined surface SL1 and the channel layer 132 includes the second inclined surface SL2, so that the source electrode 173 and the drain electrode 175 may be easily formed on the side surface of the barrier layer 136 and the side surface of the channel layer 132. That is, step coverage forming the source electrode 173 and the drain electrode 175 may be improved, and thus the source electrode 173 and the drain electrode 175 may have more stable electrical characteristics.

The source electrode 173 and the drain electrode 175 may include a conductive material. For example, the source electrode 173 and the drain electrode 175 may include a metal, a metal alloy, a conductive metal nitride, a metal silicide, a doped semiconductor material, a conductive metal oxide, a conductive metal oxynitride, or the like. However, example embodiments are not limited thereto. For example, the source electrode 173 and the drain electrode 175 may include, for example, at least one of a titanium nitride (TiN), a tantalum carbide (TaC), a tantalum nitride (TaN), a titanium silicon nitride (TiSiN), a tantalum silicon nitride (TaSiN), a tantalum titanium nitride (TaTiN), a titanium aluminum nitride (TiAlN), a tantalum aluminum nitride (TaAlN), a tungsten nitride (WN), ruthenium (Ru), a titanium aluminum (TiAl), a titanium aluminum carbonitride (TiAlC-N), a titanium aluminum carbide (TiAlC), a titanium carbide (TiC), a tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), a niobium nitride (NbN), a niobium carbide (NbC), molybdenum (Mo), a molybdenum nitride (MoN), a molybdenum carbide (MoC), a tungsten carbide (WC), rhodium (Rh), palladium (Pd), iridium (Ir), osmium (Os), silver (Ag), gold (Au), zinc (Zn), vanadium (V), and a combination thereof, but example embodiments are not limited thereto. The source electrode 173 and the drain electrode 175 may be configured as a single layer or multilayer. The source electrode 173 and the drain electrode 175 may be in ohmic contact with the channel layer 132. A region in contact with the source electrode 173 and the drain electrode 175 in the channel layer 132 may be doped at a relatively high concentration compared to other regions.

FIG. 1 to FIG. 5 illustrate that the semiconductor device according to various example embodiments includes a pair of source electrodes 173 and drain electrodes 175, but the number of source electrode 173 and drain electrode 175 is not limited thereto. For example, each of the source electrode 173 and the drain electrode 175 may include two or more layers.

The semiconductor device according to the embodiment may further include a field dispersion layer 177 disposed on the passivation layer 180.

The field dispersion layer 177 may be disposed between the source electrode 173 and the drain electrode 175. The field dispersion layer 177 may cover the gate electrode 155. The field dispersion layer 177 may overlap the gate electrode 155 in the third direction (Z direction). The field dispersion layer 177 may be electrically connected to the source electrode 173. For example, the field dispersion layer 177 may be connected to the source electrode 173.

In various example embodiments, the field dispersion layer 177 may include the same material as the source electrode 173, and may be disposed on the same layer as the source electrode 173. The field dispersion layer 177 may be simultaneously formed in the same process as the source electrode 173. That is, a boundary between the field dispersion layer 177 and the source electrode 173 is not clear, and the field dispersion layer 177 may be integrally formed with the source electrode 173. However, example embodiments are not limited thereto, and the field dispersion layer 177 may be a separate constituent element from the source electrode 173. In addition, the field dispersion layer 177 may be disposed in a different layer from the source electrode 173, and may be formed in a different process. In some cases, the field dispersion layer 177 may be electrically connected to the gate electrode 155. For example, an opening that overlaps the gate electrode 155 in a vertical direction may be formed in the passivation layer 180, and the field dispersion layer 177 may be connected to the gate electrode 155 through the opening. In this case, the field dispersion layer 177 may not be connected to the source electrode 173.

The field dispersion layer 177 may serve to disperse an electric field concentrated around the gate electrode 155. In the gate-off state, the two-dimensional electron gas 134 may be disposed at a very high concentration in a portion of the channel layer 132 disposed between the gate electrode 155 and the source electrode 173 and a portion of the channel layer 132 disposed between the gate electrode 155 and the drain electrode 175. An electric field may be particularly concentrated on a portion of the channel layer 132 adjacent to the gate electrode 155. Accordingly, a leakage current may increase, and a breakdown voltage may decrease. Since the semiconductor device according to various example embodiments includes the field dispersion layer 177, the electric field concentrated around the gate electrode 155 may be dispersed. Accordingly, the leakage current may be decreased, and the breakdown voltage may be increased.

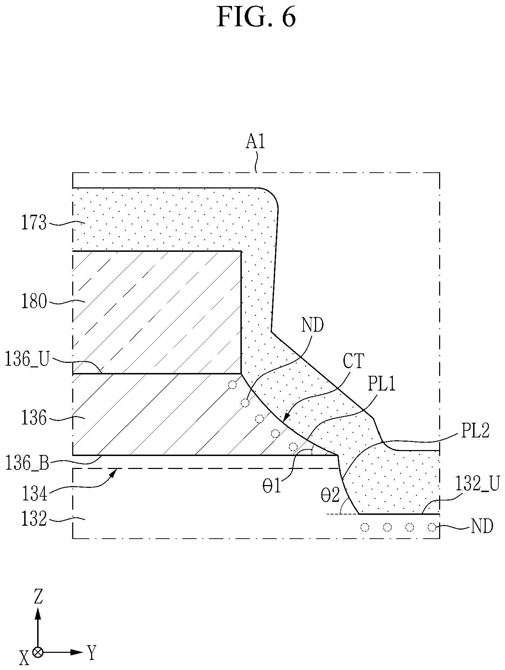

Hereinafter, a semiconductor device according to some embodiments will be described with further reference to FIG. 6 to FIG. 14.

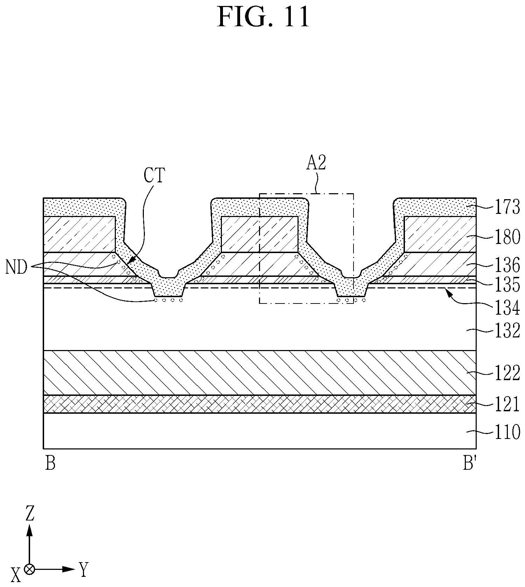

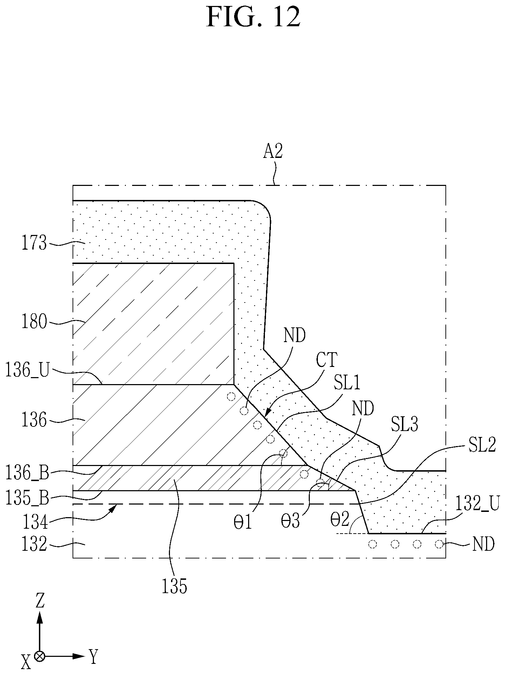

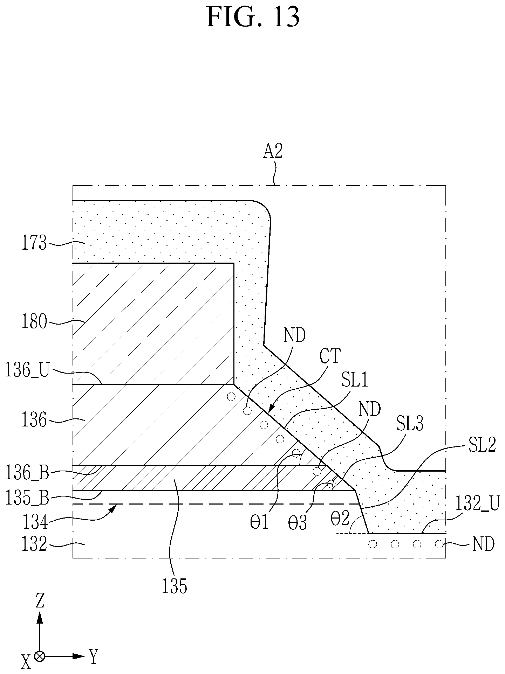

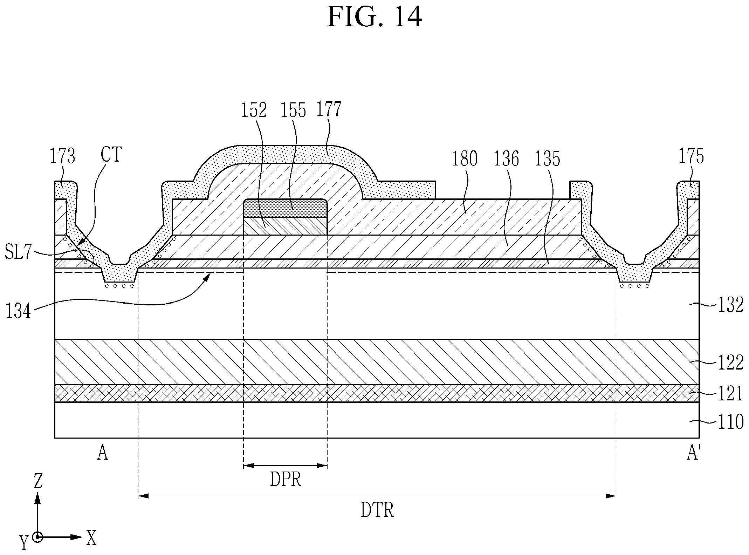

FIG. 6 to FIG. 8 illustrate cross-sectional views corresponding to area "A1" of FIG. 4 illustrating a semiconductor device according to some example embodiments. FIG. 9 to FIG. 11 illustrate cross-sectional views of a semiconductor device according to some example embodiments. FIG. 12 illustrates an enlarged cross-sectional view of area "A2" of FIG. 11. FIG. 13 illustrates a cross-sectional view of area "A2" of FIG. 12 illustrating a semiconductor device according to some embodiments. FIG. 14 illustrates a cross-sectional view of a semiconductor device according to some embodiments.

FIG. 6 to FIG. 14 illustrate various modified examples of the semiconductor device according to various example embodiments illustrated in FIG. 1 to FIG. 5. The embodiment illustrated in FIG. 6 to FIG. 14 has considerably the same portions as the example embodiments illustrated in FIG. 1 to FIG. 5, so a description thereof will be omitted and differences will be mainly described. In addition, the same reference numerals are used for components that are the same as those of the previous embodiment. In various example embodiments illustrated in FIG. 6 to FIG. 14, the shape and/or disposition of the barrier layer may be partially different from the previous embodiment.

Referring to FIG. 2, FIG. 4, and FIG. 6 to FIG. 14, the semiconductor device according to some example embodiments includes a channel layer 132, a barrier layer 136 disposed on the channel layer 132, a gate electrode 155 disposed on the barrier layer 136, a gate semiconductor layer 152 disposed between the barrier layer 136 and the gate electrode 155, a passivation layer 180 disposed on the barrier layer 136, and a source electrode 173 and a drain electrode 175 spaced apart from each other on the channel layer 132.

The semiconductor device according to some example embodiments may include a source/drain trench CT that penetrates the passivation layer 180 and the barrier layer 136 and recesses at least a portion of the channel layer 132. The source/drain trench CT may include side surfaces facing each other in the first direction (X direction) and side surfaces facing each other in the second direction (Y direction). The source electrode 173 and the drain electrode 175 may be disposed within the source/drain trench CT.

Referring to FIG. 6, in some example embodiments, the side surface of the barrier layer 136 and the side surface of the channel layer 132 may include curved surfaces.

For example, the side surfaces of the barrier layer 136 facing each other in the second direction (Y direction) may include first curved surfaces PL1. The first curved surface PL1 may have a concave shape toward the inside of the barrier layer 136. For example, a first angle θ1 between a tangent line of the first curved surface PL1 and the lower surface 136_B of the barrier layer 136 may be greater than 0° and less than or equal to 70°. Within this range, the first curved surface PL1 of the barrier layer 136 may be easily doped with the impurities ND. Accordingly, a width of the upper surface 136_U of the barrier layer 136 in the second direction (Y direction) may be smaller than a width of the lower surface 136_B of the barrier layer 136 in the second direction (Y direction).

In addition, the side surfaces of the channel layer 132 facing each other in the second direction (Y direction) may include second curved surfaces PL2. The second curved surface PL2 may have a concave shape toward the inside of the channel layer 132. A second angle θ2 between the second curved surface PL2 and the upper surface 132_U of the channel layer 132 may be greater than or equal to the first angle θ1. Here, the upper surface 132_U of the channel layer 132 may mean a surface defining the lower surface of the source/drain trench CT.

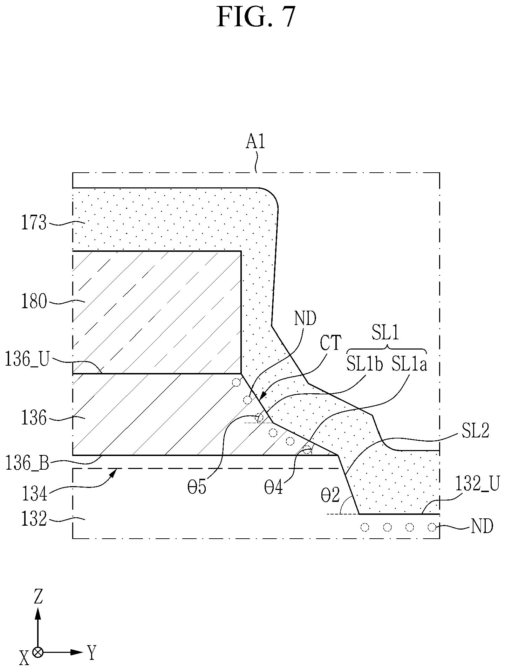

Referring to FIG. 7, the side surface of the barrier layer 136 may include a plurality of inclined portions. For example, the side surfaces of the barrier layer 136 facing each other in the second direction (Y direction) may include a first inclined portion SL1a and a second inclined portion SL1b. The first inclined portion SL1a and the second inclined portion SL1b may be surfaces inclined at a desired (or, alternatively an empirically or predetermined) angle from the lower surface 136_B of the barrier layer 136. For example, a fourth angle θ4 between the first inclined portion SL1a and the lower surface 136_B of the barrier layer 136 may be greater than 0° and less than or equal to 70°, and a fifth angle θ5 between the second inclined portion SL1b and the lower surface 136_B of the barrier layer 136 may be greater than the fourth angle θ4 between the first inclined portion SL1a and the lower surface 136_B of the barrier layer 136. Within this range, the first inclined surface SL1 of the barrier layer 136 may be easily doped with the impurities ND. Accordingly, a width of an upper surface 136_U of the barrier layer 136 in the second direction (Y direction) may be smaller than a width of the lower surface 136_B of the barrier layer 136 in the second direction (Y direction). However, example embodiments are not limited thereto, and the fifth angle θ5 between the second inclined portion SL1b and the lower surface 136_B of the barrier layer 136 may be smaller than the fourth angle θ4 between the first inclined portion SL1a and the lower surface 136_B of the barrier layer 136.

In FIG. 7, the side surface of the barrier layer 136 is described as including two inclined portions, but example embodiments are not limited thereto. For example, the side surface of the barrier layer 136 may include three or more inclined portions. In addition, the side surface of the channel layer 132 is shown as not including an inclined portion, but example embodiments are not limited thereto. For example, the side surface of the channel layer 132 may include two or more inclined portions.

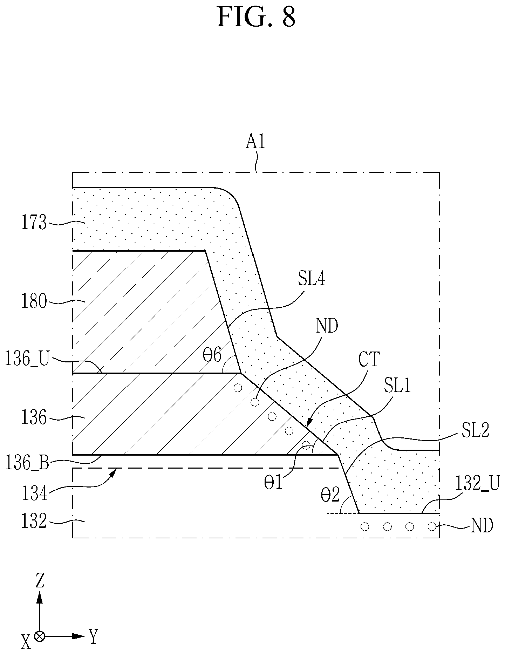

Referring to FIG. 8, the side surface of the passivation layer 180 according to some example embodiments may include an inclined surface.

For example, the side surfaces of the passivation layer 180 facing each other in the second direction (Y direction) may include a fourth inclined surface SL4. The fourth inclined surface SL4 of the passivation layer 180 may be a surface inclined at a desired (or, alternatively an empirically or predetermined) angle from the lower surface of the passivation layer 180. For example, a sixth angle θ6 between the fourth inclined surface SL4 and the lower surface of the passivation layer 180 may be greater than or equal to the first angle θ1 between the first inclined surface SL1 and the lower surface 136_B of the barrier layer 136. Accordingly, a width of the upper surface of the passivation layer 180 in the second direction (Y direction) may be smaller than a width of the lower surface of the passivation layer 180 in the second direction (Y direction). As the side surface of the passivation layer 180 has an inclined surface, the source electrode 173 and the drain electrode 175 may be easily formed on the side surface of the passivation layer 180. That is, step coverage forming the source electrode 173 and the drain electrode 175 may be improved, and thus the source electrode 173 and the drain electrode 175 may have more stable electrical characteristics.

However, it example embodiments are not limited thereto, and the side surface of the passivation layer 180 may have a concave shape toward the inside of the passivation layer 180, as in the example embodiments of FIG. 6, or may include a plurality of inclined portions.

Referring to FIG. 9, the side surfaces of the barrier layer 136 facing each other in the first direction (X direction) and the side surfaces of the channel layer 132 facing each other in the first direction (X direction) according to some example embodiments may further include inclined surfaces.

In some example embodiments, the side surfaces of the barrier layer 136 facing each other in the first direction (X direction) may include a fifth inclined surface SL5. The fifth inclined surface SL5 may be a surface inclined at a desired (or, alternatively an empirically or predetermined) angle from the lower surface 136_B of the barrier layer 136. For example, an angle between the fifth inclined surface SL5 and the lower surface 136_B of the barrier layer 136 may be greater than 0° and less than or equal to 70°. Within this range, the impurities ND may be easily doped on the fifth inclined surface SL5 of the barrier layer 136. Accordingly, a width of an upper surface 136_U of the barrier layer 136 in the first direction (X direction) may be smaller than a width of the lower surface 136_B of the barrier layer 136 in the first direction (X direction). Accordingly, a region of the channel layer 132 overlapping the barrier layer 136 in the third direction (Z direction) relatively increases, so that the drift region DTR may increase.

In addition, the side surfaces of the channel layer 132 facing each other in the first direction (X direction) may include a sixth inclined surfaces SL6. The sixth inclined surface SL6 may be a surface inclined at a desired (or, alternatively an empirically or predetermined) angle from the upper surface 132_U of the channel layer 132. An angle between the sixth inclined surface SL6 and the upper surface 132_U of the channel layer 132 may be greater than or equal to an angle between the fifth inclined surface SL5 and the lower surface 136_B of the barrier layer 136. This may be due to the process characteristics of simultaneously forming the fifth inclined surface SL5 of the barrier layer 136 and the sixth inclined surface SL6 of the channel layer 132 by using an etching material having an etching rate higher in the channel layer 132 than in the barrier layer 136 in the process of etching the channel layer 132 and the barrier layer 136 together. Here, the upper surface 132_U of the channel layer 132 may mean a surface defining the lower surface of the source/drain trench CT.

However, example embodiments are not limited thereto, and in the process of etching the channel layer 132 and the barrier layer 136 together, the first inclined surface SL1 and the second inclined surface SL2 may be simultaneously formed by adjusting the etching conditions so that the etching rate of the channel layer 132 is higher than that of the barrier layer 136.

Referring to FIG. 10 to FIG. 14, the semiconductor device according to some example embodiments may further include a spacer layer 135 disposed between the channel layer 132 and the barrier layer 136.

The spacer layer 135 may be disposed on the channel layer 132. The spacer layer 135 may be disposed between the channel layer 132 and the barrier layer 136. The spacer layer 135 may overlap the barrier layer 136 in the third direction (Z direction). The spacer layer 135 may include AlN.

In some example embodiments, the source/drain trench CT may penetrate the passivation layer 180, the barrier layer 136, and the spacer layer 135, and recess at least a portion of the channel layer 132.

In some example embodiments, the side surface of the source/drain trench CT may be defined as a side surface of the channel layer 132, a side surface of the spacer layer 135, a side surface of the barrier layer 136, and a side surface of the passivation layer 180. For example, the side surfaces of the source/drain trench CT facing each other in the first direction (X direction) may be defined as the side surfaces of the channel layer 132 facing each other in the first direction (X direction), the side surfaces of the spacer layer 135 facing each other in the first direction (X direction), the side surfaces of the barrier layer 136 facing each other in the first direction (X direction), and the side surfaces of the passivation layer 180 facing each other in the first direction (X direction). In addition, the side surfaces of the source/drain trench CT facing each other in the second direction (Y direction) may be defined as the side surfaces of the channel layer 132 facing each other in the second direction (Y direction), the side surfaces of the spacer layer 135 facing each other in the second direction (Y direction), the side surfaces of the barrier layer 136 facing each other in the second direction (Y direction), and the side surfaces of the passivation layer 180 facing each other in the second direction (Y direction).

In this case, the side surface of the spacer layer 135 may include an inclined surface. For example, as shown in FIG. 11 and FIG. 12, the side surfaces of the spacer layer 135 facing each other in the second direction (Y direction) may include a third inclined surface SL3. The third inclined surface SL3 may be a surface inclined at a desired (or, alternatively an empirically or predetermined) angle from the lower surface of the spacer layer 135. For example, a third angle θ3 between the third inclined surface SL3 and the lower surface of the spacer layer 135 may be smaller than the first angle θ1 between the first inclined surface SL1 of the barrier layer 136 and the lower surface 136_B of the barrier layer 136. This may be due to the process characteristics of simultaneously forming the first inclined surface SL1 of the barrier layer 136 and the third inclined surface SL3 of the spacer layer 135 by using an etching material having an etching rate higher in the barrier layer 136 than in the spacer layer 135 in the process of etching the spacer layer 135 and the barrier layer 136 together. However, example embodiments are not limited thereto, and in the process of etching the spacer layer 135 and the barrier layer 136 together, the first inclined surface SL1 and the third inclined surface SL3 may be simultaneously formed by adjusting the etching conditions so that the etching rate of the barrier layer 136 is higher than that of the spacer layer 135.

Alternatively, as another example, as illustrated in FIG. 13, the third angle θ3 between the third inclined surface SL3 of the spacer layer 135 and the lower surface of the spacer layer 135 may be substantially the same as the first angle θ1 between the first inclined surface SL1 of the barrier layer 136 and the lower surface 136_B of the barrier layer 136. That is, the third inclined surface SL3 of the spacer layer 135 and the first inclined surface SL1 of the barrier layer 136 may extend straightly. However, even in this case, it may be smaller than the second angle θ2 between the second inclined surface SL2 of the channel layer 132 and the upper surface 132_U of the channel layer 132. Accordingly, a width of the upper surface of the spacer layer 135 in the second direction (Y direction) may be smaller than a width of the lower surface 135_B of the spacer layer 135 in the second direction (Y direction). Meanwhile, the side surfaces of the spacer layer 135 facing each other in the first direction (X direction) may be vertical surfaces perpendicular to the lower surface of the spacer layer 135, but are not limited thereto.

In some example embodiments, the third inclined surface SL3 of the spacer layer 135 may be disposed below the first inclined surface SL1 of the barrier layer 136. The third inclined surface SL3 of the spacer layer 135 may be disposed between the first inclined surface SL1 of the barrier layer 136 and the second inclined surface SL2 of the channel layer 132.

In some example embodiments, the third inclined surface SL3 of the spacer layer 135 may be doped with impurities. The impurities doped on the third inclined surface SL3 of the spacer layer 135 may include the same material as the impurities doped on the first inclined surface SL1 of the barrier layer 136 and the impurities doped on the upper surface 132_U of the channel layer 132. For example, the third inclined surface SL3 of the spacer layer 135 may be doped with n-type impurities. The third inclined surface SL3 of the spacer layer 135 may be doped with Si, Ge, or a combination thereof. However, example embodiments are not limited thereto. The impurities ND may be doped substantially uniformly on the third inclined surface SL3 of the spacer layer 135. That is, the entire third inclined surface SL3 of the spacer layer 135 may be doped with the impurities ND.

Referring to FIG. 14, the side surfaces of the spacer layer 135 facing each other in the first direction (X direction) according to some embodiments may further include an inclined surface.

In some example embodiments, the side surfaces of the spacer layer 135 facing each other in the first direction (X direction) may include a seventh inclined surface SL7. The seventh inclined surface SL7 may be a surface inclined at a desired (or, alternatively an empirically or predetermined) angle from the lower surface 136_B of the spacer layer 135. For example, an angle between the seventh inclined surface SL7 and the lower surface of the spacer layer 135 may be substantially the same as the angle between the third inclined surface SL3 of the spacer layer 135 and the lower surface of the spacer layer 135 of the example embodiments of FIG. 12. Accordingly, a width of the upper surface of the spacer layer 135 in the first direction (X direction) may be smaller than a width of the lower surface of the spacer layer 135 in the first direction (X direction).

In various example embodiments represented by FIG. 10 to FIG. 14, the side surface of the spacer layer 135, the side surface of the barrier layer 136, and the portion of the side surface of the channel layer 132 may include an inclined surface, and the angle between the side surface of the spacer layer 135 and the lower surface of the spacer layer 135 may be relatively small. Accordingly, as the area of the exposed spacer layer 135 increases, the side surface of the spacer layer 135 may be doped with impurities at a high concentration. Through this, the side of the spacer layer 135 may function as a carrier implant layer.

Hereinafter, a semiconductor device according to some example embodiments will be described with reference to FIG. 2 and FIG. 15 to FIG. 18.

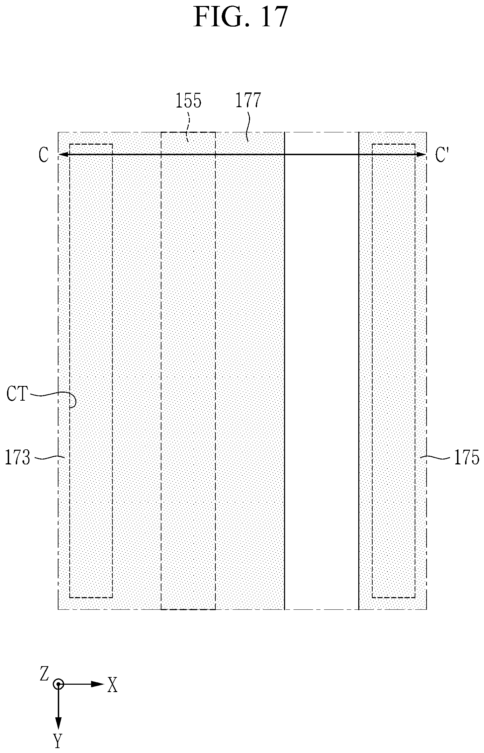

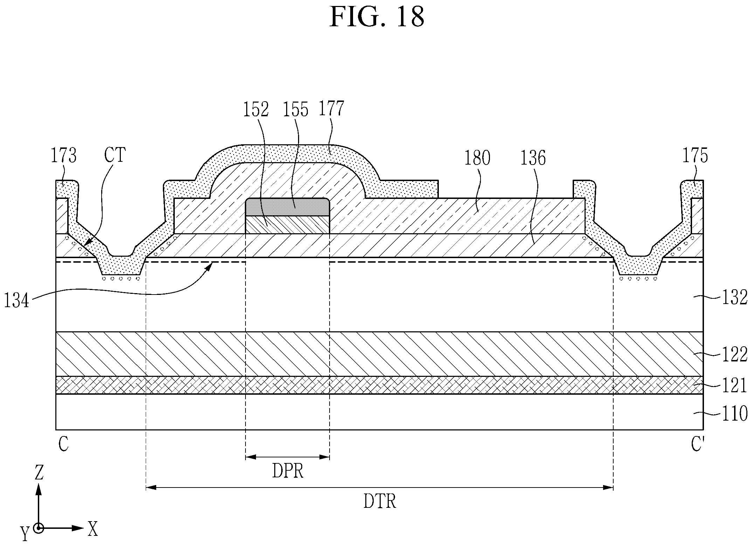

FIG. 15 to FIG. 17 illustrate top plan views of a semiconductor device according to some example embodiments. FIG. 18 illustrates a cross-sectional view taken along line C-C' of FIG. 17.

Referring to FIG. 2 and FIG. 15 to FIG. 17, the semiconductor device according to some example embodiments includes a channel layer 132, a barrier layer 136 disposed on the channel layer 132, a gate electrode 155 disposed on the barrier layer 136, a gate semiconductor layer 152 disposed between the barrier layer 136 and the gate electrode 155, a passivation layer 180 disposed on the barrier layer 136, and a source electrode 173 and a drain electrode 175 spaced apart from each other on the channel layer 132.

The semiconductor device according to some example embodiments may include a source/drain trench CT that penetrates the passivation layer 180 and the barrier layer 136 and recesses at least a portion of the channel layer 132. The source/drain trenches CT may be disposed on both sides of the gate electrode 155 to be spaced apart from each other in the first direction (X direction). In addition, a plurality of source/drain trenches CT may be provided, and the plurality of source/drain trenches CT may be arranged along the second direction (Y direction). The plurality of source/drain trenches CT may be disposed to be spaced apart from each other in the second direction (Y direction). The source electrode 173 and the drain electrode 175 may be disposed within the source/drain trench CT.

The source/drain trench CT may have various shapes in a plan view. For example, as shown in FIG. 15, the source/drain trench CT may include a rounded shape in a plan view. That is, side surfaces of the source/drain trench CT facing each other in the first direction (X direction) may have a rounded shape, and side surfaces of the source/drain trench CT facing each other in the second direction (Y direction) may be flat. As another example, as shown in FIG. 16, the source/drain trench CT may have an elliptical shape in a plan view. In this case, a radius of the source/drain trench CT in the first direction (X direction) may be larger than a radius of the source/drain trench CT in the second direction (Y direction). In this case, the plurality of source/drain trenches CT may be arranged along the second direction (Y direction). The cross-sectional shape of the source/drain trench CT according to some example embodiments is substantially the same as the example embodiments of FIG. 1 to FIG. 5, so it will be omitted.

Referring to FIG. 17, the source/drain trenches CT are disposed on both sides of the gate electrode 155, and may extend in the second direction (Y direction). The source/drain trench CT may have a quadrangular shape in a plan view. For example, the source/drain trench CT may have a rectangular shape with a long side extending along the second direction (Y direction). In this case, as shown in FIG. 18, the side surfaces of the barrier layer 136 facing each other in the first direction (X direction) and the side surfaces of the channel layer 132 facing each other in the first direction (X direction) according to some example embodiments may include inclined surfaces. In addition, the side surfaces of the barrier layer 136 facing each other in the first direction (X direction) may be doped with impurities. The remaining description of the side surfaces of the barrier layer 136 facing each other in the first direction (X direction) and the side surfaces of the channel layer 132 facing each other in the first direction (X direction) are substantially the same as the embodiment of FIG. 8, so it will be omitted.

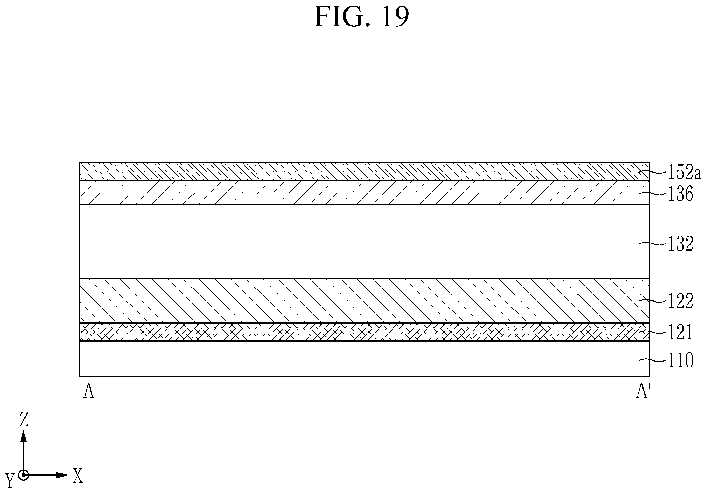

Hereinafter, a manufacturing method of a semiconductor device according to an embodiment will be described with reference to FIG. 19 to FIG. 27.

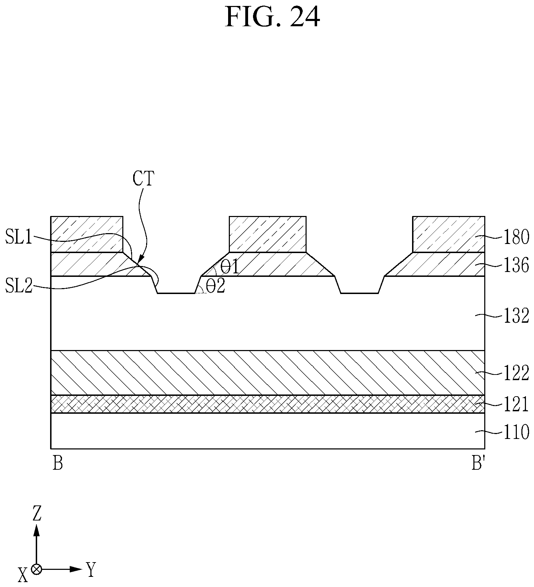

FIG. 19 to FIG. 27 illustrate process cross-sectional views of a process sequence of manufacturing a semiconductor device according to an embodiment. FIG. 19 to FIG. 23 and FIG. 26 illustrate cross-sectional views corresponding to line A-A' of FIG. 1. FIG. 24, FIG. 25, and FIG. 27 illustrate cross-sectional views corresponding to line B-B' of FIG. 1.

First, as illustrated in FIG. 19, a seed layer 121, a buffer layer 122, a channel layer 132, a barrier layer 136, and a gate semiconductor material layer 152a may be sequentially formed on a substrate 110.

The substrate 110 may include a semiconductor material. For example, the substrate 110 may include sapphire, Si, SiC, AlN, GaN, or a combination thereof. The substrate 110 may be a silicon on insulator (SOI) substrate. However, the material of the substrate 110 in the example embodiments are not limited thereto, and all generally used substrates may be applied.

The seed layer 121, the buffer layer 122, the channel layer 132, the barrier layer 136, and the gate semiconductor material layer 152a may be sequentially formed using an epitaxial growth method. The seed layer 121 may be first formed on the substrate 110, and the buffer layer 122 may be formed on the seed layer 121. Subsequently, the channel layer 132 may be formed on the buffer layer 122, the barrier layer 136 may be formed on the channel layer 132, and the gate semiconductor material layer 152a may be formed on the barrier layer 136. Although not shown, the spacer layer 135 (see FIG. 10) may be further formed between the channel layer 132 and the barrier layer 136, as in the example embodiments of FIG. 10 to FIG. 14. Alternatively, the buffer layer 122 may further include an ultralattice layer and a high-resistance layer. In the final structure of the semiconductor device according to various example embodiments, the ultralattice layer and the high-resistance layer may be formed in the buffer layer 122 to be disposed below the channel layer 132.

The seed layer 121, the buffer layer 122, the channel layer 132, the barrier layer 136, and the gate semiconductor material layer 152a may be made of the same semiconductor material. However, the material composition ratios of respective layers may be different in consideration of the role of respective layers and the performance required for the semiconductor device. The seed layer 121, the buffer layer 122, the channel layer 132, the barrier layer 136, and the gate semiconductor material layer 152a may include one or more materials selected from nitrides including group III-V materials such as Al, Ga, In, B, or a combination thereof. However, example embodiments are not limited thereto. The seed layer 121, the buffer layer 122, the channel layer 132, the barrier layer 136, and the gate semiconductor material layer 152a may be AlₓIn_{y}Ga_{1-x-y}N(0≤x≤1, 0≤y≤1, x+y≤1).For example, the seed layer 121, the buffer layer 122, the channel layer 132, the barrier layer 136, and the gate semiconductor material layer 152a may include AlN, GaN, InN, InGaN, AlGaN, AlInN, AlInGaN, or a combination thereof. However, example embodiments are not limited thereto. The barrier layer 136 may include a material having an energy band gap different from that of the channel layer 132. The barrier layer 136 may have a higher energy band gap than the channel layer 132. The gate semiconductor material layer 152a may include a material having an energy band gap different from that of the barrier layer 136.

For example, the substrate 110 may include Si, the seed layer 121 may include AlN, and the buffer layer 122 may include GaN. The channel layer 132 may include GaN, and the barrier layer 136 may include AlGaN. The channel layer 132 and the barrier layer 136 may or may not be doped with impurities. The gate semiconductor material layer 152a may include GaN, and may be doped with impurities. The gate semiconductor material layer 152a may be doped with p-type impurities, for example, magnesium (Mg).

As the lattice structure of Si and the lattice structure of GaN are different, it may not be easy to grow the channel layer 132 made of GaN directly on the substrate 110 made of Si. In the manufacturing method of the semiconductor device according to various example embodiments, the lattice structure of the channel layer 132 may be stably formed by forming the seed layer 121 and the buffer layer 122 on the substrate 110 first and then forming the channel layer 132.

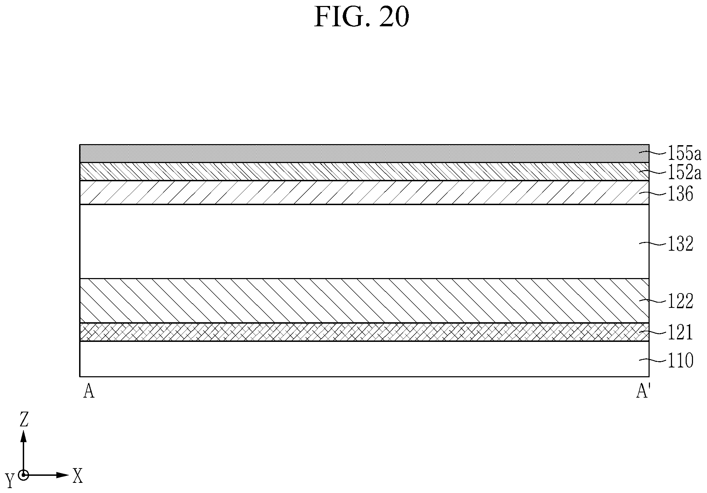

As shown in FIG. 20, a gate electrode material layer 155a may be formed on the gate semiconductor material layer 152a. The gate semiconductor material layer 152a is disposed between the barrier layer 136 and the gate electrode material layer 155a.

The gate electrode material layer 155a may be formed using a deposition process. For example, the gate electrode material layer 155a may be formed using at least one of physical vapor deposition (PVD), thermal chemical vapor deposition (thermal CVD), low pressure chemical vapor deposition (LP-CVD), plasma enhanced chemical vapor deposition (PE-CVD), or atomic layer deposition (ALD) technologies, but example embodiments are not limited thereto.

The gate electrode material layer 155a may include a conductive material. For example, the gate electrode material layer 155a may include a metal, a metal alloy, a conductive metal nitride, a metal silicide, a doped semiconductor material, a conductive metal oxide, a conductive metal oxynitride, or the like. For example, the gate electrode material layer 155a may include, for example, at least one of a titanium nitride (TiN), a tantalum carbide (TaC), a tantalum nitride (TaN), a titanium silicon nitride (TiSiN), a tantalum silicon nitride (TaSiN), a tantalum titanium nitride (TaTiN), a titanium aluminum nitride (TiAlN), a tantalum aluminum nitride (TaAlN), a tungsten nitride (WN), ruthenium (Ru), a titanium aluminum (TiAl), a titanium aluminum carbonitride (TiAlC-N), a titanium aluminum carbide (TiAlC), a titanium carbide (TiC), a tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), a niobium nitride (NbN), a niobium carbide (NbC), molybdenum (Mo), a molybdenum nitride (MoN), a molybdenum carbide (MoC), a tungsten carbide (WC), rhodium (Rh), palladium (Pd), iridium (Ir), osmium (Os), silver (Ag), gold (Au), zinc (Zn), vanadium (V), and a combination thereof, but example embodiments are not limited thereto. The gate electrode material layer 155a may be formed as a single layer or a multilayer.

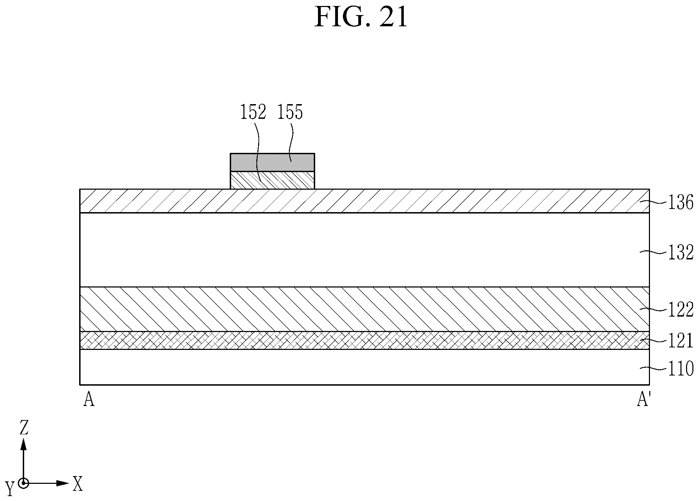

Next, as shown in FIG. 21, the gate electrode 155 and the gate semiconductor layer 152 may be formed by patterning the gate electrode material layer 155a and the gate semiconductor material layer 152a using photo and etching processes.

For example, a hard mask layer and a photoresist layer may be sequentially formed on the gate electrode material layer 155a. A photoresist pattern may be formed by patterning the photoresist layer using a photo process. A hard mask pattern may be formed by etching the hard mask layer using the photoresist pattern as a mask. By continuously etching the gate electrode material layer 155a and the gate semiconductor material layer 152a using the hard mask pattern as a mask, at least a portion of the gate electrode material layer 155a and the gate semiconductor material layer 152a may be removed. Accordingly, the remaining portion of the gate electrode material layer 155a may become the gate electrode 155. In addition, the remaining portion of the gate semiconductor material layer 152a may become the gate semiconductor layer 152. The gate semiconductor layer 152 is disposed between the barrier layer 136 and the gate electrode 155. The gate electrode 155 may be in ohmic contact or Schottky contact with the gate semiconductor layer 152.

By patterning the gate semiconductor material layer 152a and the gate electrode material layer 155a using the same mask, the gate semiconductor layer 152 and the gate electrode 155 may have the same pattern. That is, the gate semiconductor layer 152 and the gate electrode 155 may have the same planar shape. In a cross-sectional view, the gate semiconductor layer 152 and the gate electrode 155 may have the same width. The gate semiconductor layer 152 may completely overlap the gate electrode 155 in a vertical direction, and the upper surface of the gate semiconductor layer 152 may be entirely covered by the gate electrode 155. However, example embodiments are not limited thereto, and for example, the gate electrode 155 and the gate semiconductor layer 152 may have different widths. In this case, the gate electrode 155 and the gate semiconductor layer 152 may be patterned using different masks. For example, the gate electrode 155 may be patterned using the photoresist pattern, and the gate semiconductor layer 152 may be patterned using the hard mask pattern.

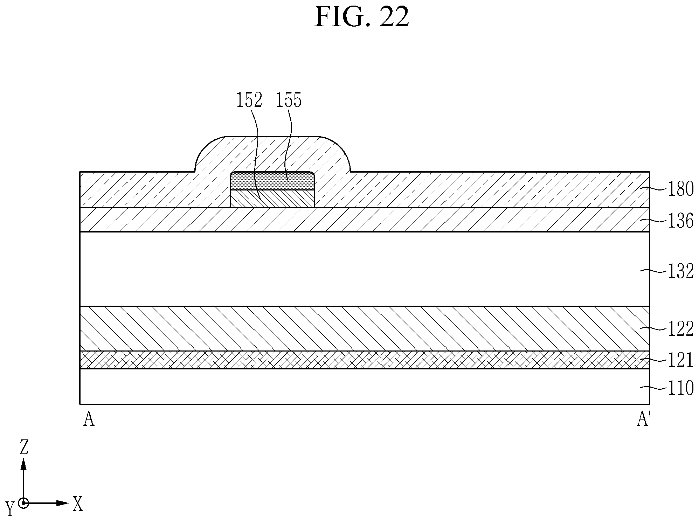

As shown in FIG. 22, the passivation layer 180 may be formed on the barrier layer 136 and the gate electrode 155. The passivation layer 180 may be formed using a deposition process. In the embodiment, the passivation layer 180 may include an insulating material. For example, the passivation layer 180 may include a silicon oxide (SiO₂). Alternatively, the passivation layer 180 may include a material such as a silicon nitride (SiN), an aluminum oxide (Al₂O₃), and the like. However, example embodiments are not limited thereto.

In FIG. 22, the passivation layer 180 is shown as a single layer, but in some cases, it may be formed as a multilayer. In this case, the passivation layer 180 may be formed by sequentially depositing different materials. Alternatively, the passivation layer 180 formed of several layers with different characteristics may be formed by using the same material and varying the deposition conditions.

The side surfaces of the gate electrode 155 and the gate semiconductor layer 152 may be covered by the passivation layer 180. The side surfaces of the gate electrode 155 and the gate semiconductor layer 152 may be in contact with the passivation layer 180. A step may occur between the portion of the passivation layer 180 overlapping the gate electrode 155 and the gate semiconductor layer 152 and the remaining portion thereof. However, example embodiments are not limited thereto, and in some cases, the upper surface of the passivation layer 180 may be entirely flat. For example, when the thickness of the passivation layer 180 is formed to be relatively thick, a step may not occur between the portion of the passivation layer 180 that overlaps the gate electrode 155 and the gate semiconductor layer 152 and the remaining portion thereof.

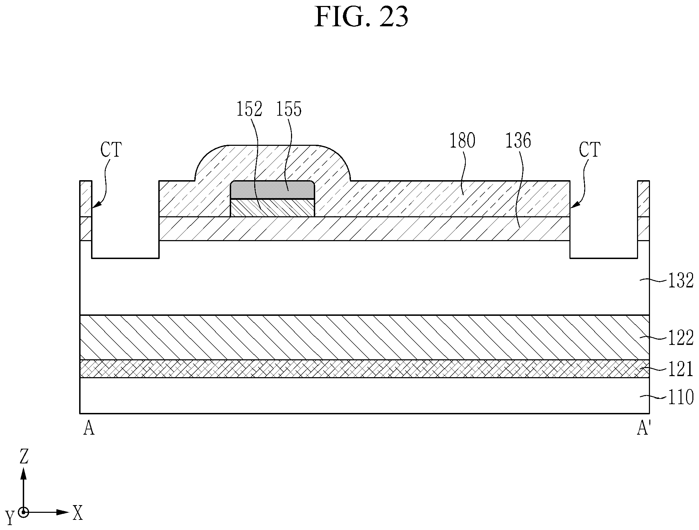

As illustrated in FIG. 23 and FIG. 24, the source/drain trench CT may be formed by patterning the passivation layer 180 using a photo and etching process. In this case, not only the passivation layer 180 but also at least a portion of the barrier layer 136 and the channel layer 132 may be patterned.

For example, a photoresist pattern may be formed on the passivation layer 180, and the source/drain trench CT may be formed by sequentially etching the passivation layer 180, the barrier layer 136, and the channel layer 132 using the photoresist pattern as a mask. In this case, the passivation layer 180 and the barrier layer 136 may be penetrated by the source/drain trench CT, and the upper surface of the channel layer 132 may be recessed. The channel layer 132 may not be penetrated by the source/drain trench CT. That is, the depth at which the upper surface of the channel layer 132 is recessed may be smaller than the entire thickness of the channel layer 132. In this case, the depth at which the upper surface of the channel layer 132 is recessed may be much smaller than the entire thickness of the channel layer 132. In addition, the depth at which the upper surface of the channel layer 132 is recessed may be smaller than the thickness of the barrier layer 136. However, example embodiments are not limited thereto, and the depth at which the upper surface of the channel layer 132 is recessed may be variously changed.

In various example embodiments, the source/drain trenches CT may be spaced apart from each other in the first direction (X direction) on both sides of the gate electrode 155. The source/drain trench CT may have a quadrangular shape in a plan view. For example, the source/drain trench CT may have a rectangular shape with a long side extending along the first direction (X direction). However, example embodiments are not limited thereto, and the source/drain trench CT may have various shapes in a plan view.

The side surface of the source/drain trench CT may be defined as a side surface of the channel layer 132, a side surface of the barrier layer 136, and a side surface of the passivation layer 180. For example, the side surfaces of the source/drain trench CT facing each other in the first direction (X direction) may be defined as the side surfaces of the channel layer 132 facing each other in the first direction (X direction), the side surfaces of the barrier layer 136 facing each other in the first direction (X direction), and the side surfaces of the passivation layer 180 facing each other in the first direction (X direction). In addition, the side surfaces of the source/drain trench CT facing each other in the second direction (Y direction) may be defined as the side surfaces of the channel layer 132 facing each other in the second direction (Y direction), the side surfaces of the barrier layer 136 facing each other in the second direction (Y direction), and the side surfaces of the passivation layer 180 facing each other in the second direction (Y direction).

In various example embodiments, a process of etching the channel layer 132 and the barrier layer 136 together to form the source/drain trench CT may be performed using a dry etching process. In this case, the channel layer 132 and the barrier layer 136 may be simultaneously etched using an etch material having an etch rate higher in the channel layer 132 than in the barrier layer 136. For example, when the channel layer 132 includes GaN and the barrier layer 136 includes AlGaN, the channel layer 132 and the barrier layer 136 may be etched using a material having a low etch rate with respect to aluminum (Al). In this case, the first angle θ1 between the first inclined surface SL1 of the barrier layer 136 and the lower surface 136_B of the barrier layer 136 may be formed to be smaller than the second angle θ2 between the second inclined surface SL2 of the channel layer 132 and the upper surface 132_U of the channel layer 132. As another example, as in the example embodiments of FIG. 10 to FIG. 14, when the channel layer 132 includes GaN, the barrier layer 136 includes AlGaN, and the spacer layer 135 includes AlN, the channel layer 132, the barrier layer 136, and the spacer layer 135 may be etched using a material having a low etch rate with respect to aluminum (Al). In this case, the first angle θ1 between the first inclined surface SL1 of the barrier layer 136 and the lower surface 136_B of the barrier layer 136 may be formed to be smaller than the second angle θ2 between the second inclined surface SL2 of the channel layer 132 and the upper surface 132_U of the channel layer 132. In addition, the third angle θ3 between the third inclined surface SL3 of the spacer layer 135 and the lower surface of the spacer layer 135 may be formed to be smaller than the first angle θ1 between the first inclined surface SL1 of the barrier layer 136 and the lower surface 136_B of the barrier layer 136. In various example embodiments, the process may be simplified by forming the first inclined surface SL1 of the barrier layer 136 and the second inclined surface SL2 of the channel layer 132 using a single etching process.

Accordingly, as shown in FIG. 24, the side surfaces of the barrier layer 136 facing each other in the second direction (Y direction) may include the first inclined surface SL1. The first inclined surface SL1 may be a surface inclined at a desired (or, alternatively an empirically or predetermined) angle from the lower surface 136_B of the barrier layer 136. For example, the first angle θ1 between the first inclined surface SL1 and the lower surface 136_B of the barrier layer 136 may be greater than 0° and less than or equal to 70°. In addition, the side surfaces of the channel layer 132 facing each other in the second direction (Y direction) may include the second inclined surface SL2. The second inclined surface SL2 may be a surface inclined at a desired (or, alternatively an empirically or predetermined) angle from the upper surface 132_U of the channel layer 132. The second angle θ2 between the second inclined surface SL2 and the upper surface 132_U of the channel layer 132 may be greater than or equal to the first angle θ1.

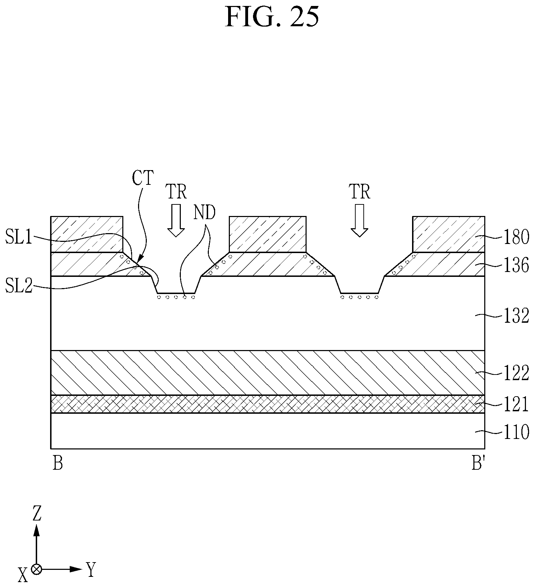

Referring to FIG. 25, the first inclined surface SL1 of the barrier layer 136 and the upper surface 132_U of the channel layer 132 may be doped with impurities. For example, the first inclined surface SL1 of the barrier layer 136 and the upper surface 132_U of the channel layer 132 may be doped with n-type impurities. The first inclined surface SL1 of the barrier layer 136 and the upper surface 132_U of the channel layer 132 may be doped with Si, Ge, or a combination thereof. However, example embodiments are not limited thereto. For example, the first inclined surface SL1 of the barrier layer 136 and the upper surface 132_U of the channel layer 132 may be doped with impurities by an ion implant process, a plasma treatment process, a heat treatment process, or the like. In this case, since the barrier layer 136 includes the first inclined surface SL1 having a desired (or, alternatively an empirically or predetermined) angle from the lower surface of the barrier layer 136, when the dopant TR is implanted in the third direction (Z direction), the first inclined surface SL1 of the barrier layer 136 may be easily doped. Accordingly, the carrier may be additionally implanted through the first inclined surface SL1 of the barrier layer 136. In other words, the first inclined surface SL1 of the barrier layer 136 may function as an additional carrier implant passage.

Although not shown in the drawings, in the embodiment, the second inclined surface SL2 of the channel layer 132 may be doped with impurities. In this case, since the second angle θ2 between the second inclined surface SL2 of the channel layer 132 and the upper surface of the channel layer 132 is greater than or equal to the first angle θ1 between the first inclined surface SL1 of the barrier layer 136 and the lower surface 136_B of the barrier layer 136, the concentration of the impurities doped on the second inclined surface SL2 of the channel layer 132 may be less than the concentration of the impurities ND doped on the upper surface 132_U of the channel layer, but example embodiments are not limited thereto.

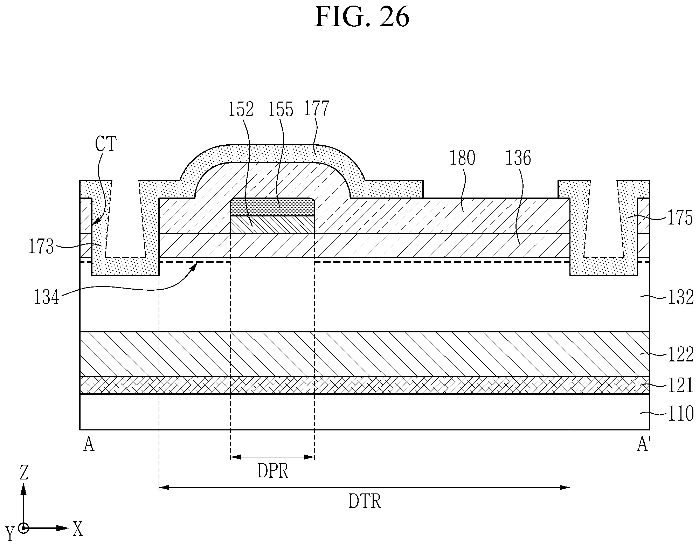

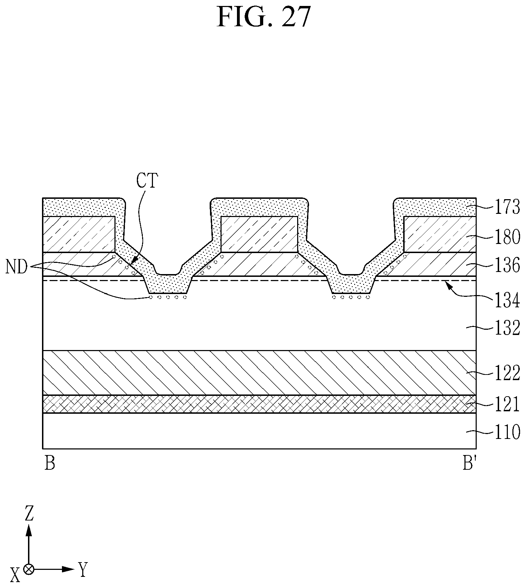

As shown in FIG. 26 and FIG. 27, a conductive material may be deposited in the source/drain trench CT and patterned to form the source electrode 173 and the drain electrode 175.

The source electrode 173 and the drain electrode 175 may be formed on the upper surface 132_U of the channel layer 132, the second inclined surface SL2 of the channel layer 132, the first inclined surface SL1 of the barrier layer 136, the side surface of the passivation layer 180, and the upper surface of the passivation layer 180. The source electrode 173 may be in contact with the channel layer 132 and the barrier layer 136 in the source/drain trench CT. The source electrode 173 may be in contact with the first inclined surface SL1 of the channel layer 132 and the barrier layer 136. The source electrode 173 may cover the first inclined surface SL1 of the channel layer 132 and the barrier layer 136. The source electrode 173 may be electrically connected to the channel layer 132 through the source/drain trench CT.

In addition, the drain electrode 175 may be in contact with the channel layer 132 and the barrier layer 136 in the source/drain trench CT. The drain electrode 175 may be in contact with the first inclined surface SL1 of the channel layer 132 and the barrier layer 136. The drain electrode 175 may cover the first inclined surface SL1 of the channel layer 132 and the barrier layer 136. The drain electrode 175 may be electrically connected to the channel layer 132 through the source/drain trench CT.

The source electrode 173 and the drain electrode 175 may include a conductive material. For example, the source electrode 173 and the drain electrode 175 may include a metal, a metal alloy, a conductive metal nitride, a metal silicide, a doped semiconductor material, a conductive metal oxide, a conductive metal oxynitride, or the like. However, example embodiments are not limited thereto. The source electrode 173 and the drain electrode 175 may be formed as a single layer or multilayer. For example, a plurality of conductive layers including different materials may be stacked and then patterned to form the source electrode 173 and the drain electrode 175. In this case, the plurality of conductive layers may be etched simultaneously or sequentially using one mask pattern. For example, the source electrode 173 and the drain electrode 175 may be formed by sequentially stacking Ti, Al, Ti, and TiN and then patterning them. However, example embodiments are not limited thereto. In this case, thicknesses of four conductive layers configuring the source electrode 173 and the drain electrode 175 may be similar or different. For example, a layer made of Al may be relatively thick compared to other layers.

The source electrode 173 and the drain electrode 175 may be in ohmic contact with the channel layer 132. Inside the channel layer 132, the two-dimensional electron gas 134 may be formed in a portion adjacent to the barrier layer 136. The two-dimensional electron gas 134 may be disposed at the interface between the channel layer 132 and the barrier layer 136. The two-dimensional electron gas 134 may be disposed in the drift region DTR between the source electrode 173 and the drain electrode 175. The depletion region DPR may be formed in the channel layer 132 by the gate semiconductor layer 152 having an energy band gap different from that of the barrier layer 136. Accordingly, the semiconductor device according to the embodiment may have a normally-off characteristic. That is, the semiconductor device according to the embodiment may be a normally-off high electron mobility transistor (HEMT). In the gate-off state, the two-dimensional electron gas 134 may be disposed in the drift region DTR excluding the depletion region DPR of the channel layer 132. In the gate-on state, the flow of the two-dimensional electron gas 134 continues within the depletion region DPR, and the two-dimensional electron gas 134 may be entirely disposed within the drift region DTR.

In the forming of the source electrode 173 and the drain electrode 175, the field dispersion layer 177 may be formed together. The field dispersion layer 177 may be disposed between the source electrode 173 and the drain electrode 175. The field dispersion layer 177 may overlap the gate electrode 155. The field dispersion layer 177 may be electrically connected to the source electrode 173. The field dispersion layer 177 may be integrally formed with the source electrode 173. The field dispersion layer 177 may include the same material as the source electrode 173, and may be disposed on the same layer as the source electrode 173.

According to the manufacturing method of the semiconductor device according to various example embodiments, the source electrode 173 and the drain electrode 175 may be formed on the first inclined surface SL1 on which the barrier layer 136 has a desired (or, alternatively an empirically or predetermined) angle from the lower surface of the barrier layer 136. In this case, the first inclined surface SL1 of the barrier layer 136 may be doped with impurities, and this may function as an implant passage of a carrier. Thus, an additional carrier may be implanted through the first inclined surface SL1 of the barrier layer 136, and contact resistance between the source electrode 173 and the drain electrode 175 and the semiconductor layer (for example, the barrier layer 136 and the channel layer 132) may be improved. That is, the semiconductor device according to various example embodiments may have more stable electric characteristics.

In addition, the barrier layer 136 includes the first inclined surface SL1 and the channel layer 132 includes the second inclined surface SL2, so that the source electrode 173 and the drain electrode 175 may be easily formed on the side surface of the barrier layer 136 and the side surface of the channel layer 132. That is, step coverage forming the source electrode 173 and the drain electrode 175 may be improved, and thus the source electrode 173 and the drain electrode 175 may have more stable electrical characteristics.

While various example embodiments of the inventive concepts have been described in connection with what is presently considered to be practical example embodiments, it is to be understood that the disclosure is not limited to the disclosed example embodiments, but, on the contrary, is intended to cover various modifications and equivalent arrangements included within the scope of the appended claims.

## Claims

1. A semiconductor device comprising:
a channel layer;
a barrier layer on the channel layer and including a material having an energy band gap different from that of the channel layer;
a gate electrode on the barrier layer;
a gate semiconductor layer between the barrier layer and the gate electrode; and
a source electrode and a drain electrode on opposite sides of the gate electrode and penetrating at least a portion of the barrier layer and the channel layer to cover a side surface of the barrier layer and a side surface of the channel layer,
wherein the side surface of the barrier layer is inclined from an upper surface of the channel layer and includes a first inclined surface doped with an impurity,
the side surface of the channel layer includes a second inclined surface inclined from the upper surface of the channel layer, and
a first angle between a lower surface of the barrier layer and the first inclined surface of the barrier layer is smaller than or equal to a second angle between the upper surface of the channel layer and the second inclined surface of the channel layer.

2. The semiconductor device of claim 1, wherein
the first angle is greater than 0 degrees and less than or equal to 70 degrees.

3. The semiconductor device of claim 1 or claim 2, wherein
the first inclined surface of the barrier layer is doped with an n-type impurity.

4. The semiconductor device of any preceding claim, wherein
the impurity includes silicon, germanium, or a combination thereof.

5. The semiconductor device of any preceding claim, wherein
the upper surface of the channel layer is doped with the same material as the impurity doped on the first inclined surface of the barrier layer.

6. The semiconductor device of claim 5, wherein
a concentration of the impurity doped on the first inclined surface of the barrier layer is smaller than a concentration of the impurity doped on the upper surface of the channel layer.

7. The semiconductor device of any preceding claim, further comprising
a passivation layer covering the barrier layer and the gate electrode,
wherein the source electrode and the drain electrode cover a side surface of the passivation layer.

8. The semiconductor device of claim 7, wherein
the side surface of the passivation layer includes an inclined surface inclined from the upper surface of the channel layer.

9. The semiconductor device of any preceding claim, further comprising
a spacer layer between the channel layer and the barrier layer,
wherein a side surface of the spacer layer includes a third inclined surface inclined from the upper surface of the channel layer.

10. The semiconductor device of claim 9, wherein
a third angle between the third inclined surface of the spacer layer and a lower surface of the spacer layer is less than or equal to the first angle.

11. The semiconductor device of claim 9 or claim 10, wherein
a third angle between the third inclined surface of the spacer layer and a lower surface of the spacer layer is less than or equal to the second angle.

12. The semiconductor device of any preceding claim, wherein
the gate electrode extends in a first direction,
the side surfaces of the barrier layer facing each other in the first direction include at least part of the first inclined surface that is inclined from the upper surface of the channel layer, and
the side surfaces of the channel layer facing each other in the first direction include at least part of the second inclined surface inclined from the upper surface of the channel layer.

13. The semiconductor device of claim 12, wherein
the side surfaces of the barrier layer facing each other in a second direction crossing the first direction include a further part of the first inclined surface that is inclined from the upper surface of the channel layer, and
each of the side surfaces of the channel layer facing each other in the second direction includes a further part of the second inclined surface inclined from the upper surface of the channel layer.

14. The semiconductor device of claim 12 or claim 13, wherein
a width of the upper surface of the barrier layer in the first direction is smaller than a width of the lower surface of the barrier layer in the first direction.

15. The semiconductor device of claim 13 or claim 14 when dependent upon claim 13, wherein
a width of the upper surface of the barrier layer in the second direction is smaller than a width of the lower surface of the barrier layer in the second direction.

## Amended claims

### Amended claims in accordance with Rule 137(2) EPC.

1. A semiconductor device comprising:
a channel layer (132);
a barrier layer (136) on the channel layer (132) and including a material having an energy band gap different from that of the channel layer (132);
a gate electrode (155) on the barrier layer (136);
a gate semiconductor layer (152) between the barrier layer (136) and the gate electrode (155); and
a source electrode (173) and a drain electrode (175) on opposite sides of the gate electrode (155) and penetrating at least a portion of the barrier layer (136) and the channel layer (132) to cover a side surface of the barrier layer (136) and a side surface of the channel layer (132),
wherein the side surface of the barrier layer (136) is inclined from an upper surface of the channel layer (132) and includes a first inclined surface (SL1) doped with an impurity,
the side surface of the channel layer (132) includes a second inclined surface (SL2) inclined from the upper surface of the channel layer (132), and
a first angle (θ1) between a lower surface of the barrier layer (136) and the first inclined surface (SL1) of the barrier layer (136) is smaller than a second angle (θ2) between the upper surface of the channel layer (132) and the second inclined surface (SL2) of the channel layer (132).

2. The semiconductor device of claim **1,** wherein
the first angle (θ1) is greater than 0 degrees and less than or equal to 70 degrees.

3. The semiconductor device of claim 1 or claim 2, wherein
the first inclined surface (SL1) of the barrier layer (136) is doped with an n-type impurity.

4. The semiconductor device of any preceding claim, wherein
the impurity includes silicon, germanium, or a combination thereof.

5. The semiconductor device of any preceding claim, wherein
the upper surface of the channel layer (132) is doped with the same material as the impurity doped on the first inclined surface (SL1) of the barrier layer (136).

6. The semiconductor device of claim 5, wherein
a concentration of the impurity doped on the first inclined surface (SL1) of the barrier layer (136) is smaller than a concentration of the impurity doped on the upper surface of the channel layer (132).

7. The semiconductor device of any preceding claim, further comprising
a passivation layer (180) covering the barrier layer (136) and the gate electrode (155),
wherein the source electrode (173) and the drain electrode (175) cover a side surface of the passivation layer (180).

8. The semiconductor device of claim 7, wherein
the side surface of the passivation layer (180) includes an inclined surface inclined from the upper surface of the channel layer (132).

9. The semiconductor device of any preceding claim, further comprising
a spacer layer between the channel layer (132) and the barrier layer (136),
wherein a side surface of the spacer layer includes a third inclined surface (SL3) inclined from the upper surface of the channel layer (132).

10. The semiconductor device of claim 9, wherein
a third angle (θ3) between the third inclined surface (SL3) of the spacer layer and a lower surface of the spacer layer is less than or equal to the first angle (θ1).

11. The semiconductor device of claim 9 or claim 10, wherein
a third angle (θ3) between the third inclined surface (SL3) of the spacer layer and a lower surface of the spacer layer is less than or equal to the second angle (θ2).

12. The semiconductor device of any preceding claim, wherein
the gate electrode (155) extends in a first direction (X direction),
the side surfaces of the barrier layer (136) facing each other in the first direction (X) include at least part of the first inclined surface (SL1) that is inclined from the upper surface of the channel layer (132), and
the side surfaces of the channel layer (132) facing each other in the first direction (X) include at least part of the second inclined surface (SL2) inclined from the upper surface of the channel layer (132).

13. The semiconductor device of claim 12, wherein
the side surfaces of the barrier layer (136) facing each other in a second direction (Y)crossing the first direction (X) include a further part of the first inclined surface (SL1) that is inclined from the upper surface of the channel layer (132), and
each of the side surfaces of the channel layer (132) facing each other in the second direction (Y) includes a further part of the second inclined surface (SL2) inclined from the upper surface of the channel layer (132).

14. The semiconductor device of claim 12 or claim 13, wherein
a width of the upper surface (136_U) of the barrier layer (136) in the first direction (X) is smaller than a width of the lower surface (136_B) of the barrier layer (136) in the first direction (X).

15. The semiconductor device of claim 13 or claim 14 when dependent upon claim 13, wherein
a width of the upper surface (136_U) of the barrier layer (136) in the second direction (Y) is smaller than a width of the lower surface (136_B) of the barrier layer (136) in the second direction (Y).
